(19) Europäisches Patentamt
European Patent Office
Office européen des brevets

(11) EP 1 085 583 A2

# (12) EUROPEAN PATENT APPLICATION

(43) Date of publication:
**21.03.2001 Bulletin 2001/12**

(51) Int. Cl.[7]: **H01L 33/00**, H01S 5/343, H01L 31/068, H01L 31/0304

(21) Application number: **00118585.9**

(22) Date of filing: **25.08.2000**

(84) Designated Contracting States:
**AT BE CH CY DE DK ES FI FR GB GR IE IT LI LU MC NL PT SE**
Designated Extension States:
**AL LT LV MK RO SI**

(30) Priority: **27.08.1999 JP 24165299**

(71) Applicant:
**Canare Electric Co., Ltd.**
**Aichi-gun, Aichi-ken 480-1101 (JP)**

(72) Inventor: **Kano, Hiroyuki**
**Nishikamo-gun, Aichi-ken 470-0201 (JP)**

(74) Representative:
**Leson, Thomas Johannes Alois, Dipl.-Ing. et al**
**Patentanwälte**
**Tiedtke-Bühling-Kinne & Partner,**
**Bavariaring 4**
**80336 München (DE)**

## (54) Semiconductor devices with quantum-wave inference layers

(57) A light-emitting diode 100 having a double hetero junction structure, in which an emission layer 13 made of i-$Ga_{0.89}In_{0.11}As$ is sandwiched by an n-cladding layer 12 made of n-$Al_{0.5}Ga_{0.5}As$ and a p-cladding layer 15 made of p-$Al_{0.5}Ga_{0.5}As$, comprises an electron reflection layer (eR) 14 between the emission layer 13 and the p-cladding layer 15. The electron reflection layer (eR) 14 has a multiple quantum layer structure with 20 periods of a p-GaAs well layer as a first layer W and a p-$Al_{0.5}Ga_{0.5}As$ barrier layer as a second layer B. Each thickness of the first and the second layers is determined by one fourth of a quantum-wave wavelength of electrons in each of the first and the second layers. As a result, luminous intensity of the light-emitting diode is improved.

FIG. 8

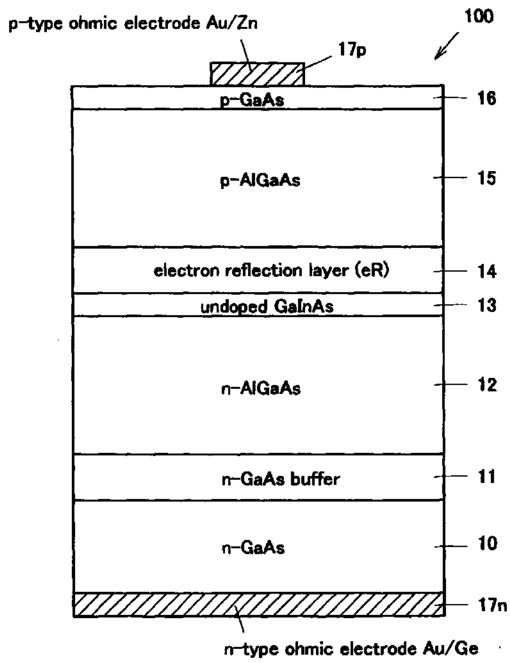


EP 1 085 583 A2

## Description

### BACKGROUND OF THE INVENTION

### Field of the invention

The present invention relates to a gallium arsenide (GaAs) compound group semiconductor device having quantum-wave interference layers which reflect carriers, i.e., electrons or holes, effectively. The present invention also relates to a gallium arsenide (GaAs) semiconductor device having quantum-wave interference layers which transmit carriers, i.e., electrons or holes, effectively. Especially, the present invention relates to a light-emitting device such as a laser or a light-emitting diode with a structure which confines carriers in an active layer so as to improve its luminous efficiency.

### Description of the Related Art

A semiconductor device has been known to have a double hetero junction structure whose active layer is formed between n-type and p-type cladding layers. The cladding layers function as potential barriers for effectively confining carriers, or electrons and holes, within the active layer.

However, a problem persists in luminous efficiency. Carriers overflow the potential barriers of the cladding layers, which lowers luminous efficiency. Therefore, further improvement has been required, as presently appreciated by the present inventors.

As a countermeasure, forming cladding layers having a multiple quantum well structure of a first and a second layer as a unit in a laser diode in order to reflect carriers has been suggested by Takagi et al. (Japanese Journal of Applied Physics. Vol. 29, No.11, November 1990, pp.L1977-L1980). This reference, however, does not teach or suggest values of kinetic energy of carriers to be considered.

### SUMMARY OF THE INVENTION

The inventor of the present invention conducted a series of experiments and found that, although it can be understood that Takagi et al. used a band gap energy alternative to a kinetic energy, the suggested thickness of the first and the second layers by Takagi et al. were too small to confine electrons, and that preferable thicknesses of the first and second layers are 4 to 6 times larger than those suggested by Takagi et al. So a problem still persisted in inadequacy of reflecting carriers.

Further, the present inventor thought that multiple quantum-wave reflection of carriers might occur by a multiple layer structure with different band width, like multiple light reflection by a dielectric multi-film structure. And the inventor thought that it would be possible to confine carriers by the reflection of the quantum-wave interference layer and filed an application with respect to this (Japanese Patent Application laid-open No. H10-303406).

Then the inventor of the present invention concerned a characteristic of electrons as a wave and considered that the quantum-wave interference layer functions as a transmission layer of carriers, by analogy with the multiple reflection of the light. That is, when each thickness of layers in the multiple layer structure is about an order of the wavelength of a quantum-wave of carriers, an interference effect of quantum-wave is considered to occur with respect to a conduction of carriers in the multiple layer structure. The interference effect caused a conduction as a wave. Accordingly, the inventor of the present invention considered that not a conduction of particle in a classical theory but a resonance of waves, an interference, or other phenomenon is occurred by an interference effect of electrons. This wave behavioral characteristic of electrons improves a mobility and a propagation velocity.

It is, therefore, a first object of the present invention is to provide a semiconductor device with a new structure, having a quantum-wave interference layer with a large reflectivity to carriers which functions as a reflection layer or a quantum-wave interference layer with a high transmittivity and a high mobility to carriers which functions as a transmission layer.

In light of these objects a first characteristic group of this invention is described as follows. A first aspect of the present invention is a semiconductor device constituted by a quantum-wave interference layer having plural periods of a pair of a first layer made of $Al_xGa_{1-x}As$ and a second layer made of $Al_yGa_{1-y}As$ ($0 \leqq x < y \leqq 1$), the second layer having a wider band gap than the first layer. Each thickness of the first and the second layers is determined by multiplying by an odd number one fourth of a quantum-wave wavelength of carriers in each of the first and the second layers.

A second aspect of the present invention is to form each thickness of the first and the second layers by multiplying by an odd number one fourth of quantum-wave wavelength of carriers in each of the first and the second layers existing at the level near the lowest energy level of the second layer.

A third aspect of the present invention is to define each thickness of the first and the second layers as fol-

lows:

$$D_{RW} = n_{RW}\lambda_{RW}/4 = n_{RW}h/4[2m_{RW}(E_R+V_R)]^{1/2} \quad (1\text{-}1)$$

and

$$D_{RB} = n_{RB}\lambda_{RB}/4 = n_{RB}h/4(2m_{RB}E_R)^{1/2} \quad (1\text{-}2)$$

In Eqs. 1-1 and 1-2, h, $m_{RW}$, $m_{RB}$, $E_R$, $V_R$, and $n_{RW}$, $n_{RB}$ represent Plank's constant, the effective mass of carriers in the first layer, the effective mass of carriers in the second layer, the kinetic energy of the carriers at the level near the lowest energy level of the second layer, the potential energy of the second layer relative to the first layer, and odd numbers, respectively. Carriers injected into the second layer are preferably existing around the lowest energy of the second layer.

A fourth aspect of the present invention is the first quantum-wave interference layer having a plurality of partial quantum-wave interference layers $I_{Rk}$ with arbitrary periods $T_{Rk}$ including a first layer having a thickness of $D_{RWk}$ and a second layer having a thickness of $D_{RBk}$ and arranged in series. The thicknesses of the first and the second layers satisfy the formulas:

$$D_{RWk} = n_{RWk}\lambda_{RWk}/4 = n_{RWk}h/4[2m_{RWk}(E_{Rk}+V_R)]^{1/2} \quad (2\text{-}1)$$

and

$$D_{RBk} = n_{RBk}\lambda_{RBk}/4 = n_{RBk}h/4(2m_{RBk}E_{Rk})^{1/2} \quad (2\text{-}2)$$

In Eqs. 2-1 and 2-2, $E_{Rk}$, $m_{RWk}$, $m_{RBk}$, and $n_{RWk}$, $n_{RBk}$ represent plural kinetic energy levels of carriers flowing into the second layer, effective mass of carriers with kinetic energy $E_{Rk}+V_R$ in the first layer, effective mass of carriers with kinetic energy $E_{Rk}$ in the second layer, and arbitrary odd numbers, respectively.

The plurality of the partial quantum-wave interference layers $I_{Rk}$ are arranged in series from $I_{R1}$ to $I_{Rj}$, where j is a maximum number of k required to from a quantum-wave interference layer as a whole.

A fifth aspect of the present invention is a semiconductor device having a first quantum-wave interference layer with a plurality of partial quantum-wave interference layers arranged in series with arbitrary periods. Each of the plurality of partial quantum-wave interference layers is constructed with serial pairs of the first and second layers. The widths of the first and second layers of the serial parts are represented by ($D_{RB1}$, $D_{RW1}$), ..., ($D_{RBk}$, $D_{RWk}$), ..., ($D_{RBj}$, $D_{RWj}$). ($D_{RBk}$, $D_{RWk}$) is a pair of widths of the first and second layers and is defined as Eqs 2-1 and 2-2, respectively.

A sixth aspect of the present invention is to form a $\delta_R$ layer, which varies an energy band sharply, at an interface between the first and the second layers. A thickness of the $\delta_R$ layer is substantially thinner than that of the first and the second layers.

A seventh aspect of the present invention is to provide a quantum-wave interference layer which functions as a reflection layer of carriers.

An eighth aspect of the present invention is to constitute a quantum-wave incident facet in the quantum-wave interference layer by a second layer with enough thickness for preventing conduction of carriers by a tunneling effect.

Ninth to fifteenth aspects of the present invention in a second characteristic group correspond to the first to seventh aspects of the present invention in the first characteristic group, respectively. A quantum-wave interference layer (second kind) shown in the second characteristic group has a different structure from that of the quantum-wave interference layer (first kind) shown in the first characteristic group. While the first kind of quantum-wave interference layer has a first layer and a second layer, each thickness of which is determined by multiplying by an odd number one fourth of a quantum-wave wavelength of carriers in each of the first and the second layers, the second kind of quantum-wave interference layer has a first layer and a second layer, each thickness of which is determined by multiplying by an even number one fourth of a quantum-wave wavelength of carriers in each of the first and the second layers.

A ninth aspect of the present invention, which corresponds to the first aspect of the present invention, is a semiconductor device constituted by a quantum-wave interference layer having plural periods of a pair of a first layer made of $Al_xGa_{1-x}As$ and a second layer made of $Al_yGa_{1-y}As$ ($0 \leqq x < y \leqq 1$), the second layer having a wider band gap than the first layer. Each thickness of the first and the second layers is determined by multiplying by an even number one fourth of a quantum-wave wavelength of carriers in each of the first and the second layers.

A tenth aspect of the present invention, which corresponds to the second aspect of the present invention, is to form each thickness of the first and the second layers by multiplying by an even number one fourth of quantum-wave wavelength of carriers in each of the first and the second layers existing at the level near the lowest energy level of the second layer.

An eleventh aspect of the present invention, which corresponds to the third aspect of the present invention, is to define each thickness of the first and the second layers as follows:

$$D_{TW} = n_{TW}\lambda_{TW}/4 = n_{TW}h/4[2m_{TW}(E_T+V_T)]^{1/2} \quad (3\text{-}1)$$

and

$$D_{TB} = n_{TB}\lambda_{TB}/4 = n_{TB}h/4(2m_{TB}E_T)^{1/2} \quad (3\text{-}2)$$

In Eqs. 3-1 and 3-2, h, $m_{TW}$, $m_{TB}$, $E_T$, $V_T$, and $n_{TW}$, $n_{TB}$ represent Plank's constant, the effective mass of carriers in the first layer, the effective mass of carriers in the second layer, the kinetic energy of the carriers at the level near the lowest energy level of the second layer, the potential energy of the second layer relative to the first layer, and even numbers, respectively. Carriers injected into the second layer are preferably existing around the lowest energy of the second layer.

A twelfth aspect of the present invention, which corresponds to the fourth aspect of the present invention, is a quantum-wave interference layer having a plurality of partial quantum-wave interference layers $I_{Tk}$ with arbitrary periods $T_{Tk}$ including a first layer having a thickness of $D_{TWk}$ and a second layer having a thickness of $D_{TBk}$ and arranged in series. The thicknesses of the first and the second layers satisfy the formulas:

$$D_{TWk} = n_{TWk}\lambda_{TWk}/4 = n_{TWk}h/4[(2m_{TWk}(E_{Tk}+V_T)]^{1/2} \quad (4\text{-}1)$$

and

$$D_{TBk} = n_{TBk}\lambda_{TBk}/4 = n_{TBk}h/4(2m_{TBk}E_{Tk})^{1/2} \quad (4\text{-}2)$$

In Eqs. 4-1 and 4-2, $E_{Tk}$, $m_{TWk}$, $m_{TBk}$, and $n_{TWk}$, $n_{TBk}$ represent plural kinetic energy levels of carriers flowing into the second layer, effective mass of carriers with kinetic energy $E_{Tk}+V_T$ in the first layer, effective mass of carriers with kinetic energy $E_{Tk}$ in the second layer, and arbitrary even numbers, respectively.

The plurality of the partial quantum-wave interference layers $I_{Tk}$ are arranged in series from $I_{T1}$ to $I_{Tj}$, where j is a maximum number of k required to from a quantum-wave interference layer as a whole.

A thirteenth aspect of the present invention, which corresponds to the fifth aspect of the present invention, is a semiconductor device having a quantum-wave interference layer with a plurality of partial quantum-wave interference layers arranged in series with arbitrary periods. Each of the plurality of partial quantum-wave interference layers is constructed with serial pairs of the first and second layers. The widths of the first and second layers of the serial parts are represented by ($D_{TB1}$, $D_{TW1}$), ..., ($D_{TBk}$, $D_{TWk}$), ..., ($D_{TBj}$, $D_{TWj}$). ($D_{TBk}$, $D_{TWk}$) is a pair of widths of the first and second layers and is defined as Eqs 4-1 and 4-2, respectively.

A fourteenth aspect of the present invention, which corresponds to the sixth aspect of the present invention, is to form a $\delta_T$ layer, which varies an energy band sharply, at an interface between the first and the second layers. A thickness of the $\delta_T$ layer is substantially thinner than that of the first and the second layers.

A fifteenth aspect of the present invention, which corresponds to the seventh aspect of the present invention, is to provide a quantum-wave interference layer which functions as a transmission layer of carriers.

In a third characteristic group of the present invention, the first to fifteenth aspects of the present invention is applied to a semiconductor device having a specific function. A sixteenth aspect of the present invention is a semiconductor device constituted by an n-type layer, a p-type layer, and an active layer that is formed between the n-type layer and the p-type layer, and wherein at least one of the n-type layer and the p-type layer is at least one or both of two kinds of the quantum-wave interference layer, i.e., reflection type (λ/4) and transmission type (λ/2). Carriers, or electrons and holes to reflect or transmit, can be selected arbitrary and corresponding two kinds of quantum-wave interference layer may be used for electrons and holes. Two kinds of quantum-wave interference layer may be used at the same time for either one of electrons and holes, alternatively, for both of electrons and holes.

A seventeenth aspect of the present invention is to provide a light-emitting device having the quantum-wave interference layer in at least one of an n-type cladding layer and a p-type cladding layer. The quantum-wave interference layer, which functions as a reflection layer, is used.

An eighteenth aspect of the present invention is a field effect transistor including the quantum-wave interference layer which is described in the first or the second characteristic groups of the present invention. That is, at least one of the reflection-type and the transmission-type quantum-wave interference layers is formed positioned adjacent to a channel.

A nineteenth aspect of the present invention is a photovoltaic device having a pn junction structure including an n-layer and a p-layer. At least one of the n-layer and the p-layer is made of the reflection-type quantum-wave interference layer for reflecting minor carriers.

(First to third and seventh aspects of the present invention)

The principle of the first kind of quantum-wave interference layer in the first characteristic group of the present invention is explained hereinafter. FIG. 1 shows a conduction band of a multiple layer structure with plural periods of a first layer W and a second layer B as a unit. A band gap of the second layer B is wider than that of the first layer W. Electrons conduct from left to right as shown by an arrow in FIG. 1. Among the electrons, those that exist at the level near the lowest energy level of a conduction band in the second layer B are most likely to contribute to conduction. The electrons near the bottom of conduction band of the second layer B has a kinetic energy E. Accordingly, the electrons in the first layer W have a kinetic energy E+V which is accelerated by potential energy V due to the band gap between the first layer W and the second layer B. In other words, electrons that move from the first layer W to the second layer B are decelerated by potential energy V and return to the original kinetic energy E in the second layer B. As explained above, kinetic energy of electrons in the conduction band is modulated by potential energy due to the multiple layer structure.

When thicknesses of the first layer W and the second layer B are equal to order of quantum-wave wavelength, electrons tend to have characteristics of a wave. The wave length of the electron quantum-wave is calculated by Eqs. 1-1 and 1-2 using kinetic energy of the electron. Further, defining the respective wave number vector of first layer W and second layer B as $K_W$ and $K_B$, reflectivity R of the wave is calculated by:

$$\begin{aligned} R &= (|K_W|-|K_B|) / (|K_W|+|K_B|) ] \\ &= [\{m_W(E+V)\}^{½}-(m_B E)^{½}] / [\{m_W(E+V)\}^{½}+(m_B E)^{½}] \\ &= [1-\{m_B E/m_W(E+V)\}^{½}] / [1+\{m_B E/m_W(E+V)\}^{½} \end{aligned} \quad (5).$$

Further, when $m_B = m_W$, the reflectivity R is calculated by:

$$R = [1-\{E/(E+V)\}^{½}]/[1+\{E/(E+V)\}^{½}] \quad (6).$$

When $E/(E+V) = x$, Eq. 6 is transformed into:

$$R = (1-x^{½}) / (1+x^{½}) \quad (7).$$

The characteristic of the reflectivity R with respect to the energy ratio x obtained by Eq. 7 is shown in FIG. 2. And when each of the second layer B and the first layer W is laminated S times, the reflectivity $R_S$ of the quantum-wave incident facet is calculated by:

$$R_S = [(1-x^S) / (1+x^S)]^2 \quad (8).$$

When the condition $x \leq 0.1$ is satisfied, $R \geq 0.52$. Accordingly, the relation between E and V is satisfied with:

$$E \leq V/9 \quad (9).$$

Since the kinetic energy E of the conducting electrons in the second layer B exists near the bottom of the conduction band, the relation of Eq. 9 is satisfied and the reflectivity R at the interface between the second layer B and the first layer W becomes 52 % or more. Consequently, the multiple quantum well layer structure can reflect quantum wave of electrons effectively.

Further, utilizing the energy ratio x enables the thickness ratio $D_B/D_W$ of the second layer B to the first layer W to be obtained by:

$$D_B/D_W = [m_W / (m_B x)]^{½} \quad (10).$$

Thicknesses of the first layer W and the second layer B are determined for selectively transmitting one of holes and electrons, because of a difference in potential energy between the valence and the conduction bands, and a difference in effective mass of holes and electrons in the first layer W and the second layer B. Namely, the optimum thickness of the first and the second layers for reflecting electrons is not optimum for reflecting holes. Eqs. 1-1 and 1-2 refer to a structure of the quantum-wave interference layer for reflecting electrons selectively. The thickness for selectively reflecting electrons is designed based on a difference in potential energy of the conduction band and effective mass of electrons. Consequently, the quantum-wave interference layer has a high reflectivity for electrons, but not for holes.

Further, the thickness for selectively reflecting holes is designed based on a difference in potential energy of the valence band and effective mass of holes, realizing another type of quantum-wave interference layer which can reflect holes and transmits electrons.

(Ninth to eleventh and fifteenth aspects of the present invention)

The principle of the second kinds of quantum-wave interference layer in the second characteristic group of the present invention is explained hereinafter. When thicknesses of the first layer W and the second layer B are determined by multiplying an even number by one fourth of a quantum-wave wavelength, for example, a half of a quantum-wave wavelength, a standing wave rises in a quantum-wave interference layer, and a resonant conduction is occurred. That is, when a quantum-wave period of the standing wave and a potential period of the quantum-wave interference layer is corresponded to each other, a scattering of the carrier in each layer is suppressed, and a conduction of a high mobility is realized.

Thicknesses of the first layer W and the second layer B are determined for selectively transmitting one of holes and electrons, because of a difference in potential energy between the valence and the conduction bands, and a difference in effective mass of holes and electrons in the first layer W and the second layer B. Namely, the optimum thickness of the first and the second layers for transmitting electrons is not optimum for transmitting holes. Eqs. 3-1 and 3-2 refer to a structure of the quantum-wave interference layer for transmitting electrons selectively. The thickness for selectively transmitting electrons is designed based on a difference in potential energy of the conduction band and effective mass of electrons. Consequently, the quantum-wave interference layer has a high transmittivity (or a high mobility) for electrons, but not for holes.

Further, the thickness for selectively transmitting holes is designed based on a difference in potential energy of the valence band and effective mass of holes, realizing another type of quantum-wave interference layer as a hole transmission layer, which has a high mobility for holes and which has an ordinary mobility for electrons.

Further explanation can be obtained by FIGS. 3A-3H. FIGS. 3A-3H illustrate the relationship between reflection of quantum-wave of electrons in a potential of quantum-well structure and a period of potential representing a conduction band of a multiple quantum well (MQW). FIGS. 3A-3D show the relationship when the period, i.e., width of the second layer B or the first layer W, of the potential is equal to an odd number multiplied by one fourth of the wavelength of propagated election quantum-wave. This type of the potential is named as $\lambda/4$ type potential hereinafter. FIGS. 3E-3H show when the period of the potential is equal to a natural number multiplied by a half of the wavelength of propagated electron quantum-wave. This type of the potential is named as $\lambda/2$ type potential hereinafter. In order to make it visually intelligible, thickness of each layers is unified in FIGS. 3A-3H. Electrons existing around the bottom of a conduction band of the second layer B conduct from left to right as shown by an arrow in FIGS. 3A and 3E. And in FIGS. 3B and 3F, the electrons reach the interface between the first layer W and the second layer B.

When the quantum-wave of the electrons reaches the interface between the second layer B and the first layer W in the $\lambda/4$ type potential, a transmission wave QW2 and a reflection wave QW3 having a phase equal to that of the transmission wave QW2, are generated with respect to an incident wave QW1 as shown in FIG. 3C. Then when the transmission wave QW2 reaches the interface between the first layer W and the second layer B, a transmission wave QW4 and a reflection wave QW5 having a phase opposite to that of the transmission wave QW4 are generated as shown in FIG. 3D. The relationship between phases of the transmission wave and the reflection wave at the interface depends on falling or rising of a potential of the conduction band at the interface. In order to make it visually intelligible, each amplitudes of QW1, QW2, QW3, QW4, and QW5 is unified in FIGS. 3A-3H.

With respect to the $\lambda/4$ type potential of the multiple quantum well, the propagating quantum-wave of electrons represented by QW1, QW2 and QW4 and the reflecting quantum-wave of electrons represented by QW3 and QW5 cancels with each other, as shown in FIG. 3D. The quantum-wave of electrons represented by the QW1, QW2 and QW4 propagates from left to right, and the quantum-wave of electrons represented by the QW3 and QW5, generated by the reflection at two interfaces, propagates from right to left. Accordingly, a multiple quantum well, having a potential which is formed in a period, i.e., the width of the first layer W and the second layer B, determined by multiplying by an odd number one fourth of quantum-wave wavelength of propagated electrons, cancels the quantum-wave of electrons. In short, the multiple quantum well functions as a reflection layer which does not propagate electrons.

With respect to a multiple quantum well, having a potential which is formed in a period, i.e., the width of the third layer W and the fourth layer B, determined by multiplying by an even number one fourth of quantum-wave wavelength of propagated electrons, i.e., $\lambda/2$ type potential, as shown in FIGS. 3E-3H, the quantum-wave of electrons can become a standing wave.

Similarly, when a quantum-wave of electrons reaches the interface between the second layer B and the first layer W in the $\lambda/2$ type potential, a transmission wave QW2 and a reflection wave QW3 having a phase corresponding to that of the transmission wave QW2, are generated with respect to an incident wave QW1 as shown in FIG. 3G. Then when the transmission wave QW2 reaches the interface between the first layer W and the second layer B, a transmission wave QW4 and a reflection wave QW5 having a phase opposite to that of the transmission wave QW4 are generated as shown in FIG. 3H. With respect to $\lambda/2$ type potential of the multiple quantum well, the propagating quantum-wave of electrons represented by QW1, QW2 and QW4 and the reflecting quantum-wave of electrons represented by QW5 intensifies to each other, as shown in FIG. 3H. On the other hand, the reflection waves QW3 and QW5 can be considered to cancel with each other and the quantum-wave of electrons which is propagated from left to right in FIG. 3E can be a standing wave. Accordingly, with respect to the multiple quantum well, having a potential which is formed in a period, i.e., the width of the first layer W and the second layer B, determined by multiplying by an even number one fourth of quantum-wave wavelength of propagated electrons, the quantum-wave of electrons can become a standing wave and a transmission layer having a high transmittivity (or a high mobility) for electrons can be realized.

Alternatively, a multiple quantum well, having a potential which is formed in a period determined by multiplying by a natural number half of quantum-wave wavelength of holes, can be applied to the relationship described above.

Accordingly, a semiconductor device in which both quantum-wave interference layers for electrons and holes in the first and the second characteristic groups, i.e., reflection-type and transmission-type, respectively, are formed as described above is obtained. When electrons or holes are injected from the second kinds of quantum-wave interference layer, i.e., transmission-type, to the first kinds of quantum-wave interference layer, i.e., reflection-type, electrons or holes, which are not interrupted and flows with a high transmittivity in the second kind of quantum-wave interference layer, reach the first quantum-wave interference layer and are reflected effectively. In short, carriers (electrons or holes) can be accumulated effectively between the second and the first kinds of quantum-wave interference layers and a main part to drive the device can be formed between the second and the first kinds of quantum-wave interference layers.

(Fourth and twelfth aspects of the present invention)

As shown in FIG. 4, a plurality of partial quantum-wave interference layers $I_{Rk}$ as a quantum-wave interference layer may be formed corresponding to each of a plurality of kinetic energy levels $E_{Rk}$. Each of the partial quantum-wave interference layers $I_{Rk}$ has $T_{Rk}$ periods of a first layer W and a second layer B as a unit whose respective thicknesses ($D_{RWk}$, $D_{RBk}$) are determined by Eqs. 2-1 and 2-2. The plurality of the partial quantum-wave interference layer $I_{Rk}$ is arranged in series with respect to the number k of kinetic energy levels $E_{Rk}$. That is, the quantum-wave interference layer is formed by a serial connection of $I_{R1}$, $I_{R2}$, ..., and $I_{Rj}$. As shown in FIG. 4, electrons with each of the kinetic energy levels $E_{Rk}$ are reflected by the corresponding partial quantum-wave interference layers $I_{Rj}$. Accordingly, electrons belonging to each of the kinetic energy levels from $E_{R1}$ to $E_{Rj}$ are reflected effectively. By designing the intervals between the kinetic energies to be short, thicknesses of the first layer W and the second layer B ($D_{RWk}$, $D_{RBk}$) in each of the partial quantum-wave interference layers $I_{Rk}$ vary continuously with respect to the value k. Similarly, a plurality of partial quantum-wave interference layers $I_{Tk}$ as a quantum-wave interference layer may be formed corresponding to each of a plurality, of kinetic energy levels $E_{Tk}$. Each of the partial quantum-wave interference layers $I_{Tk}$ has $T_{Tk}$ periods of a first layer W and a second layer B as a unit whose respective thicknesses ($D_{TWk}$, $D_{TBk}$) are determined by Eqs. 4-1 and 4-2. The plurality of the partial quantum-wave interference layer $I_{Tk}$ is arranged in series with respect to the number k of kinetic energy levels $E_{Tk}$. That is, the quantum-wave interference layer is formed by a serial connection of $I_{T1}$, $I_{T2}$, ..., and $I_{Tj}$. This quantum-wave interference layer becomes to have a high transmittivity (or a high mobility) with carriers. In FIG. 4, ($D_{RWk}$, $D_{RBk}$), $I_{Rk}$, and $T_{Rk}$ are not distinguished from ($D_{TWk}$, $D_{TBk}$), $I_{Tk}$, and $T_{Tk}$, respectively, and each of them is represented by $D_{Wk}$, $D_{Bk}$, $I_k$ and $T_k$.

(Fifth and thirteenth aspects of the present invention)

As shown in FIG. 5, a plurality of partial quantum-wave interference layers as a quantum-wave interference layer may be formed with an arbitrary period. Each of the partial quantum-wave interference layers $I_{R1}$, $I_{R2}$, ... is made of serial pairs of the first layer W and the second layer B with widths ($D_{RWk}$, $D_{RBk}$) determined by Eqs. 2-1 and 2-2. That is, the partial quantum-wave interference layer, e.g., $I_{R1}$, is constructed with serial layers of width ($D_{RW1}$, $D_{RB1}$), ..., ($D_{RWk}$, $D_{RBk}$), ..., ($D_{RWj}$, $D_{RBj}$). A plurality $I_{R1}$, $I_{R2}$, ... of layers such as $I_{R1}$ are connected in series to form the total quantum-wave interference layer. Accordingly, electrons of the plurality of kinetic energy levels $E_{Rk}$ are reflected by each pair of layers in each partial quantum-wave interference layers. By designing the intervals between kinetic energies to be short, thicknesses of the pair of the first layer W and the second layer B ($D_{RWk}$, $D_{RBk}$) in a certain partial quantum-wave interference layer varies continuously with respect to the value k. Similarly, a plurality of partial quantum-wave interference layers as a quantum-wave interference layer, each of which is made of serial pairs of the first layer W and the second layer B with widths ($D_{TWk}$, $D_{TBk}$) determined by Eqs. 4-1 and 4-2, may be formed with an arbitrary period. That is, the partial quantum-wave interference layer is constructed with serial layers of width ($D_{TW1}$, $D_{TB1}$), ..., ($D_{TWk}$, $D_{TBk}$), ..., ($D_{TWj}$, $D_{TBj}$). This quantum-wave interference layer becomes to have a high transmittivity (or a high mobility) with carriers. In FIG. 5, ($D_{RWk}$, $D_{RBk}$), $I_{Rk}$, and $T_{Rk}$ are not distinguished from ($D_{TWk}$, $D_{TBk}$), $I_{Tk}$, and $T_{Tk}$, respectively, and each of them is represented by $D_{Wk}$, $D_{Bk}$, $I_k$ and $T_k$.

(Sixth and fourteenth aspects of the present invention)

FIGS. 6A-6D illustrate to form a $\delta_R$ layer (disclosed as a $\delta$ layer in FIGS. 6A-6D) at the interface between the first layer W and the second layer B. The $\delta_R$ layer has a relatively thinner thickness than both of the first layer W and the second layer B and sharply varies an energy band. By sharply varying the band gap of the interfaces, the potential energy V of an energy band becomes larger substantially and the value x of Eq. 7 becomes smaller, as shown in FIGS. 6A-6D. This is shown in FIGS. 7A-7D. Without forming a $\delta_R$ layer as shown in FIG. 7A, a part of component of the first layer W and the second layer B mixes when the second layer B is laminated on the first layer W, and an energy band gap which varies sharply cannot be obtained, as shown in FIG. 7B. When a $\delta_R$ layer is formed at each interfaces of the first and the second layers as shown in FIG. 7C, even if a par of component of the first layer W and the second layer B mixes, an energy band gap varies sharply compared with the case without $\delta_R$ layers, as shown in FIG. 7D.

Variations are shown in FIGS. 6A to 6D. The $\delta_R$ layer may be formed on both ends of the every first layer W as shown in FIGS. 6A to 6D. In FIG. 6A, the $\delta_R$ layers are formed so that an energy level higher than that of the second layer B may be formed. In FIG. 6B, the $\delta_R$ layers are formed so that a band having lower bottom than that of the first layer W may be formed. In FIG. 6C, the $\delta_R$ layers are formed so that the energy level higher than that of the second layer B and the energy level lower than that of the first layer W may be formed. As an alternative to the variation shown in FIG. 6C, the $\delta_R$ layer can be formed on only either one end of every layer as shown in FIG. 6D.

A $\delta_T$ layer can be formed at the interface between the first layer W and the second layer B of the quantum-wave interference layer shown in the second characteristic group of the present invention. The $\delta_T$ layer which has a relatively thinner thickness than both of the first layer W and the second layer B of the second quantum-wave interference layer and sharply varies an energy band has the same effect as that of the $\delta_R$ layer formed at the interface between the first layer W and the second layer B of the first quantum-wave interference layer. The $\delta_T$ layer may be formed in one of a plural quantum-wave interference layers or may be formed in all of the layers.

(Eighth aspect of the present invention)

By forming a thick second layer $B_0$ at the side of an incident plane of the quantum-wave interference layer, resonance tunneling conduction can be prevented effectively and carriers are reflected effectively. In FIG. 1, the layer is represented by $B_0$.

(Sixteenth and seventeenth aspects of the present invention)

Because the quantum-wave interference layer described above can function as a reflection layer or a transmission layer of carriers, carriers are effectively accumulated in an emission layer when they are formed in a light-emitting device. Especially, when the quantum-wave interference layer as a reflection layer is formed in a cladding layer of a device having a hetero junction structure, the efficiencies of carrier confining and light-emitting are improved.

(Eighteenth aspect of the present invention)

When a quantum-wave interference layer is formed adjacent to a channel of a field effect transistor, carriers which conduct through the channel can be effectively confined therein or transmitted into the channel with high movility. As a result, an amplification factor of the transistor and signal-to-noise (S/N) ratio is improved.

(Nineteenth aspect of the present invention)

A quantum-wave interference layer is formed in p-type or n-type layer of a photovoltaic device with a pn junction structure. Minor carriers generated around the junction can be prevented from drifting to a reverse direction. As a result, opto-electric conversion efficiency can be improved.

<u>BRIEF DESCRIPTION OF THE DRAWINGS</u>

Other objects, features, and characteristics of the present invention will become apparent upon consideration of the following description and the appended claims with reference to the accompanying drawings, all of which form a part of the specification, and wherein reference numerals designate corresponding parts in the various figures, wherein:

FIG. 1 is an explanatory view of a conduction band of a quantum interference layer of the present invention;
FIG. 2 is a graph showing a relation between an energy ratio x and a reflectivity R;
FIGS. 3A-3D are explanatory views of a quantum-wave interference layer as a reflection layer of carriers;
FIGS. 3E-3H are explanatory views of a quantum-wave interference layer as a transmission layer of carriers;
FIG. 4 is an explanatory view of partial quantum-wave interference layers $I_k$ according to the present invention;
FIG. 5 is an explanatory view of partial quantum-wave interference layers $I_k$ according to the present invention;
FIGS. 6A-6D are explanatory views of configuration of δ layers according to the present invention;
FIGS. 7A-7D are views showing energy level for explaining a function of δ layers according to the present invention;
FIG. 8 is a sectional view of a first exemplary structure of a light-emitting diode 100 according to the first embodiment of the present invention;
FIGS. 9A and 9B are views showing energy diagrams of the light-emitting diode of the present invention;
FIG. 10 is a graph showing a relationship between a thickness of a first electron-wave reflection layer and its luminous intensity of the light-emitting diode 100 according to the first embodiment of the present invention;
FIG. 11 is a graph showing a relationship between a thickness of a second electron-wave reflection layer and its luminous intensity of the light-emitting diode 200 according to a second embodiment of the present invention;
FIG. 12 is a sectional view of a second exemplary structure of a light-emitting diode 200 according to the second embodiment of the present invention;
FIGS. 13A and 13b are views showing energy diagrams of the light-emitting diode 200 according to the second embodiment of the present invention;
FIG. 14 is a graph showing luminous characteristics of the light-emitting diode 200 according to the second embodiment of the present invention; and
FIG. 15 is a view showing the energy diagram of the photovoltaic device according to other embodiment of the present invention.

DETAILED DESCRIPTION OF THE PREFERRED EMBODIMENTS

The invention will be more fully understood by reference to the following examples.

Example 1

FIG. 8 is a sectional view of a light-emitting diode (LED) 100 in which a quantum-wave interference layer is formed in a p-type cladding layer. The LED 100 has a substrate 10 made of gallium arsenide (GaAs). A GaAs buffer layer 11 of n-type conduction, having a thickness generally of 0.3 μm and an electron concentration of 2 x $10^{18}/cm^3$, is formed on the substrate 10. An n-$Al_{0.5}Ga_{0.5}As$ layer as an n-type cladding layer 12, having a thickness generally of 1 μm and an electron concentration of 1 x $10^{18}/cm^3$, is formed on the buffer layer 11. A non-doped $Ga_{0.89}In_{0.11}As$ layer as an emission layer 13, having a thickness generally of 14.5nm, is formed on the cladding layer 12. An electron reflection layer (eR) 14 as a quantum-wave interference layer is formed on the emission layer 13. A p- $Al_{0.5}Ga_{0.5}As$ layer as a p-type cladding layer 15, having a thickness generally of 1μm and a hole concentration of 1 x $10^{18}/cm^3$, is formed on the electron reflection layer (eR) 14. A p-GaAs layer as a p-type contact layer 16, having a thickness generally of 0.1 μm, is formed on the cladding layer 15. An electrode layer 17n made of gold and germanium (Au/Ge), having a thickness generally of 0.2 μm, is formed so as to cover the entire back of the substrate 10. Another electrode layer 17p made of Au/Zn, having a thickness generally of 0.2 μm, is formed on some portion of the p-type contact layer 16. And the substrate 10 has a diameter of 2.0 inches and the normal direction of its main surface is offset toward the [011] axis by 15 degree from the (100) plane.

The light-emitting diode 100 was manufactured by gas source molecular beam epitaxial deposition (GS-MBE) which is an epitaxial growth method under extremely high vacuum condition. GS-MBE is different from a conventional MBE which supplies group III and V elements both from solid state sources. In GS-MBE, group III elements such as indium (In), gallium (Ga), and aluminum (Al) are supplied from a solid source and group V elements such as arsenic (As) and phosphorous (P) are supplied by heat decomposition of gas material such as $AsH_3$ and $PH_3$.

In the energy diagrams of FIGS. 9A and 9B, the n-type cladding layer 12, the emission layer 13, and the electron reflection layer (eR) 14, or a quantum-wave interference layer, are shown. FIG. 9A shows an energy level of conduction and valence bands on the condition that no external voltage is applied to the LED 100, and FIG. 9B shows the energy level on the condition that the external voltage is applied thereto. The electron reflection layer (eR) 14, or a quantum-wave interference layer, has a multiple quantum layer structure with 20 periods of a p-GaAs well layer as a first layer W and a p-$Al_{0.5}Ga_{0.5}As$ barrier layer as a second layer B. Thicknesses of the first layer W and the second layer B are respectively determined according to Eqs. 1-1 and 1-2. Accordingly, electrons injected from the n-type cladding layer 12 into the emission layer 13 are reflected effectively by the electron reflection layer (eR) 14 and confined into the emission layer 13. Although the valence band of the electron reflection layer (eR) 14 also has a multiple period of energy level, holes are designed not to be reflected thereby. The respective thickness of the first layer W and the second layer B in the electron reflection layer (eR) 14 is designed to reflect electrons only. Therefore, holes injected from the p-type cladding layer 15 pass through the electron reflection layer (eR) 14 thus reaching the emission layer 13 easily and being confined therein by the n-type cladding layer 12.

Luminous intensity was measured by varying the respective thickness of the first layer W and the second layer B. FIG. 10 shows a result when the thickness of the second layer B was fixed at 7nm and that of the first layer W was varied. As shown in FIG. 10, a peak of luminous intensity was obtained when the thickness of the first layer W was 5nm. Then, luminous intensity was measured fixing the thickness of the first layer W at 5nm and varying that of the second layer B, the result being shown in FIG. 11. When the second layer B has a thickness of 11nm, luminous intensity showed its peak. As a result, the LED 100 with the electron reflection layer (eR) 14 was found to have a maximum luminous intensity when the first layer W had a thickness of 5nm and the second layer B had a thickness of 11nm. The maximum luminous intensity was eightfold of that of a LED without the electron reflection layer (eR) 14.

Example 2

As described above, the quantum-wave interference layer comprising a p-GaAs layer and a p-$Al_{0.5}Ga_{0.5}As$ layer can be an optimum electron reflection layer when the p-GaAs layer and the p-$Al_{0.5}Ga_{0.5}As$ layer have thicknesses of 5nm and 11nm, respectively. So a quantum-wave interference layer comprising 10nm in thickness of a p-GaAs layer and 22nm in thickness of an n-$Al_{0.5}Ga_{0.5}As$ layer may function as an electron transmission layer. FIG. 12 shows a light-emitting diode (LED) 200 having this electron transmission layer and the electron reflection layer as described in Example 1. The light-emitting device 200 also has a hole reflection layer (hR), whose energy diagrams are shown in FIGS. 13A and 13B. In order to reflect holes effectively, thicknesses of a first layer hW and a second layer hB of the hole reflection layer (hR) were fixed at 1.0nm and 1.2nm, respectively.

The light-emitting device 200 has a substrate 20 made of gallium arsenide (GaAs). A buffer layer 21 made of n-GaAs, having a thickness of 0.3μm and an electron concentration of 2 x $10^{18}/cm^3$, is formed on the substrate 20. An optical reflection layer 22, which has a thickness of about 3μm and has a multiple layer structure comprising 25 pairs of an n-GaAs layer and an n-$Al_{0.5}Ga_{0.5}As$ layer, is formed on the buffer layer 21. The n-GaAs layer has a thickness of 55nm and an electron concentration of 2 x $10^{18}/cm^3$, and the n- $Al_{0.5}Ga_{0.5}As$ layer has a thickness of 63nm and an electron concentration of 2 x $10^{18}/cm^3$.

An electron transmission layer (eT) 23, which has a thickness of about 0.6μm and has a multiple layer structure comprising 20 pairs of an n-GaAs layer and an n-$Al_{0.5}Ga_{0.5}As$ layer, is formed on the optical reflection layer 22. The n-GaAs layer has a thickness of 10nm and an electron concentration of 1 x $10^{18}/cm^3$, and the n- $Al_{0.5}Ga_{0.5}As$ layer has a thickness of 22nm and an electron concentration of 1 x $10^{18}/cm^3$.

A hole reflection layer (hR) 24, which has a thickness of about 20nm and has a multiple layer structure comprising 10 pairs of an n-GaAs layer and an n-$Al_{0.5}Ga_{0.5}As$ layer, is formed on the electron transmission layer (eT) 23. The n-GaAs layer has a thickness of 1nm and an electron concentration of 1 x $10^{18}/cm^3$, and the n-$Al_{0.5}Ga_{0.5}As$ layer has a thickness of 1.2nm and an electron concentration of 1 x $10^{18}/cm^3$.

An emission 25 having a multiple layer structure is formed on the hole reflection layer (hR) 24. The following layers are laminated in the emission layer 25 on the hole reflection layer (hR) 24 in sequence: a non-doped i-$Al_{0.5}Ga_{0.5}As$ layer having a thickness of 50nm; a non-doped i-$Ga_{0.89}In_{0.11}As$ layer having a thickness of 14.5nm; a non-doped i-$Al_{0.5}Ga_{0.5}As$ layer having a thickness of 3nm; a non-doped i-$Ga_{0.89}In_{0.11}As$ layer having a thickness of 14.5mn; a non-doped i-$Al_{0.5}Ga_{0.5}As$ layer having a thickness of 3nm; a non-doped i-$Ga_{0.89}In_{0.11}As$ layer having a thickness of 14.5nm; and a non-doped i-$Al_{0.5}Ga_{0.5}As$ layer having a thickness of 50nm. The i-$Ga_{0.89}In_{0.11}As$ layer is a well layer and the i-$Al_{0.5}Ga_{0.5}As$ layer is a barrier layer. Accordingly, the emission layer 25 has a multiple quantum well (MQW) structure, and has a thickness of about 0.15 μm.

An electron reflection layer (eR) 26, which has a thickness of about 0.3 μm and has a multiple layer structure comprising 20 pairs of a p-GaAs layer and a p-$Al_{0.5}Ga_{0.5}As$ layer, is formed on the emission layer 25. The p-GaAs layer has a thickness of 5nm and a hole concentration of 1 x $10^{18}/cm^3$, and the p-$Al_{0.5}Ga_{0.5}As$ layer has a thickness of 11nm and a hole concentration of 1 x $10^{18}/cm^3$.

A p-cladding layer 27 of p-$Al_{0.5}Ga_{0.5}As$, having a hole concentration of 1 x $10^{18}/cm^3$ and a thickness of about 0.5 μm, is formed on the electron reflection (eR) layer 26. A p-type contact layer 28 made of p-GaAs, having a thickness generally of 30nm and a hole concentration of 2 x $10^{18}/cm^3$, is formed on the p-cladding layer 27. An electrode layer 29n made of gold and germanium (Au/Ge), having a thickness generally of 0.2 μm, is formed so as to cover the entire back of the substrate 20. Another electrode layer 29p made of Au/Zn, having a thickness generally of 0.2 μm, is formed on some portion of the p-contact layer 28. And the substrate 20 has a diameter of 2.0 inches and the normal direction of its main surface is offset toward the [011] axis by 15 degree from the (100) plane.

The light-emitting diode 200 was manufactured by gas source molecular beam epitaxial deposition (GS-MBE), the same method that the light-emitting diode 100 was manufactured by. Alternatively, the light-emitting diode 200 can be manufactured by metal organic chemical vapor deposition (MOCVD).

FIG. 14 shows characteristics of the light-emitting diode. Its luminous wavelength is 908nm and half-width is 12nm. A temperature dependency of luminous wavelength and half-width of the light-emitting diode 200 in a range from 20°C to 80°C was measured. The temperature dependency of luminous wavelength is from 0.06nm/°C to 0.09nm/°C and a temperature dependency of half-width is less than 0.03nm/°C. The temperature dependencies of luminous wavelength and half-width in the light-emitting diode 200 are considerably improved compared with those in a general commercial product, whose temperature dependencies of luminous wavelength and half-width are 0.2nm/°C and 0.15nm/°C, respectively. A photocoupler formed by coupling the light-emitting diode 200 and a photodiode has a frequency response characteristics of 100 to 200MHz, which is much more larger than a frequency response characteristics of a commercial product, 20MHz.

In the first embodiment, a quantum-wave interference layer for electrons is formed as a reflection layer 14. Alternatively, the electron reflection layer is not necessarily needed when the light-emitting diode 100 has a hole reflection layer. For example, a light-emitting diode, which has a hole reflection layer (hR) formed on the n-type (or the negative electrode) side of the emission layer 13 and a p-cladding layer 15 formed on the p-type (or the positive electrode side) of the emission layer 13, does not necessarily have a quantum-wave interference layer for electrons. Although electrons have larger mobility in a semiconductor compared with holes, forming a quantum-wave interference layer for holes improves effectivity of the diode.

In the second embodiment, two kinds of quantum-wave interference layers are formed for electrons in the light-emitting diode 200. The two kinds of quantum-wave interference layers function as the electron transmission layer 23 and the electron reflection layer 26, and the emission layer 25 and the hole reflection layer 24 are formed between the two kinds of quantum-wave interference layers for electrons. Alternatively, the hole reflection layer 24 is not necessarily needed. For example, a diode can be formed to have the emission layer 25, the electron transmission layer 23 formed on the n-type (or the negative electrode) side of the emission layer 25, and the electron reflection layer 26 formed on the p-type (or the positive electrode) side of the emission layer 25 and a quantum-wave interference layer for holes is not existed. In short, a light-emitting diode shown in FIG. 12 may function without the hole reflection layer 24. Because electrons have larger mobility in a semiconductor compared with holes, forming a pair of quantum-wave interference layers as an electron transmission layer and an electron reflection layer, respectively, improves effectivity of a light-emitting diode as in the present invention.

Alternatively, forming two kinds of quantum-wave interference layers for holes as a transmission layer and as a reflection layer and without forming a quantum-wave interference layer for electrons can be applied to the light-emitting diode of the present invention. Such a diode comprises an emission layer, a hole reflection layer formed on the negative electrode side of the emission layer and a hole transmission layer formed on the positive side of the emission layer. Further alternatively, the light-emitting diode can comprise both quantum-wave interference layers for holes, or a hole transmission layer and a hole reflection layer, and either one of an electron transmission layer and an electron reflection layer. Order of disposition between the electron transmission layer and the hole reflection layer or between the electron reflection layer and the hole transmission layer is arbitrary.

In the above embodiments, diodes without δ layers are shown. Because δ layers can vary band gap energy at a potential interface sharply, interference effect of quantum-wave can be more improved by forming δ layers.

The layer having a multiple period structure can be made of binary, ternary and quaternary compounds such as $Al_xGa_yIn_{1-x-y}P$ or $Al_xGa_yIn_{1-x-y}As$, selecting arbitrary composition ratio within the range of $0 \leqq x \leqq 1$, $0 \leqq y \leqq 1$, and $0 \leqq x+y \leqq 1$ .

In the present invention, a light-emitting diode was used to show the effectivity of this invention. Alternatively, using a quantum-wave interference layer, which comprises multiple periods of a pair of an $Al_xGa_{1-x}As$ first layer and an $Al_yGa_{1-y}As$ second layer whose band width is larger than that of the first layer ($0 \leqq x \leqq y \leqq 1$), as a reflection layer or a transmission layer of electrons or holes is not necessarily limited to a light-emitting diode, and can be applied to an arbitrary semiconductor device such as a photodiode, a light-receiving device (e.g., a solar battery), a bipolar or a field-effect transistor, a variable capacity device, and an arbitrary semiconductor device.

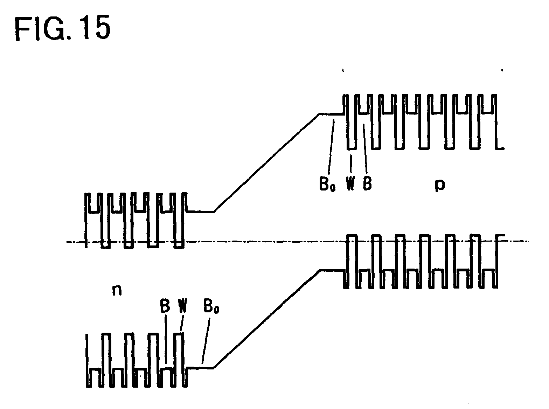

For example, a quantum-wave interference layer, which comprises an $Al_xGa_{1-x}As$ first layer and an $Al_yGa_{1-y}As$ second layer whose band width is larger than that of the first layer ($0 \leqq x \leqq y \leqq 1$), can be formed in a photovoltaic device having a pn junction structure. As shown in FIG. 15, an electron reflection layer which reflects electrons is formed in a p-layer, and a hole reflection layer which reflects holes is formed in an n-layer. When light is incided on the pn junction of the device, electron-hole pairs are generated. Most of the electrons in the device are accelerated to the n-layer due to potential declination of conduction bands while the rest of the electrons drift to the p-layer so as not to contribute to induction of voltage. The larger the intensity of the incident light becomes, the more electrons overflow to the p-layer. When a quantum-wave interference layer, or the electron reflection layer, is formed in the p-layer, drifting of electrons is prevented. That enables more electrons to conduct to the n-layer. Similarly, some of holes do not contribute to induction of voltage on account of holes drifting to the n-layer. When a quantum-wave interference layer, or the hole reflection layer, is formed in the n-layer, drifting of holes is prevented. That enables more holes to conduct to the n-layer. Consequently, leakage of current is minimized and efficiency of electro-optic convention is improved.

With respect to a light-receiving device having a pin type, $pp^-n$ type or $pn^-n$ type and pn type, it is effective to form a quantum-wave interference layer in at least one of an n-layer, a $p^-$-layer, an $n^-$-layer and a p-layer. Effectivity of such a light-receiving device can be also improved when plural quantum-wave interference layers comprising multiple periods of a pair of a first layer made of $Al_xGa_{1-x}As$ and a second layer made of $Al_yGa_{1-y}As$, whose band width is larger than that of the first layer, are formed through a middle layer which has the same band width as that of the first layer or the second layer.

Alternatively, a quantum-wave interference layer comprising multiple periods of a pair of a first layer made of $Al_xGa_{1-x}As$ and a second layer made of $Al_yGa_{1-y}As$, whose band width is larger than that of the first layer, can be formed in a base region of a bipolar transistor and a channel region of a field effect transistor.

In the present invention, to control the conduction type and resistivity, doping arbitrary impurities, or adding dopants into the first layer made of $Al_xGa_{1-x}As$ and a second layer made of $Al_yGa_{1-y}As$, can be applied. Alternatively, a part of the composition elements, or aluminum (Al), gallium (Ga) and arsenide (As), can be replaced with other elements in the same group. For example, a part of group III composition elements such as Al and Ga can be replaced with other group III elements, e.g., B, In and Tl. Also a part of group V composition elements such as As can be replaced with other group V elements, e.g., N, P, Sb and Bi.

While the invention has been described in connection with what are presently considered to be the most practical and preferred embodiments, it is to be understood that the invention is not to be limited to the disclosed embodiments, but on the contrary, the description is intended to cover various modifications and equivalent arrangements included within the spirit and scope of the appended claims. The present document claims the benefit of Japanese priority document, filed in Japan on August 27, 1999, the entire contents of which is incorporated herein by reference.

Obviously, numerous modifications and variations of the present invention are possible in light of the above teachings. It is therefore to be understood that within the scope of the appended claims, the invention may be practiced otherwise than as specifically described herein.

A light-emitting diode 100 having a double hetero junction structure, in which an emission layer 13 made of i-$Ga_{0.89}In_{0.11}As$ is sandwiched by an n-cladding layer 12 made of n-$Al_{0.5}Ga_{0.5}As$ and a p-cladding layer 15 made of p-$Al_{0.5}Ga_{0.5}As$, comprises an electron reflection layer (eR) 14 between the emission layer 13 and the p-cladding layer 15. The electron reflection layer (eR) 14 has a multiple quantum layer structure with 20 periods of a p-GaAs well layer as a first layer W and a p-$Al_{0.5}Ga_{0.5}As$ barrier layer as a second layer B. Each thickness of the first and the second layers is determined by one fourth of a quantum-wave wavelength of electrons in each of the first and the second layers. As a result, luminous intensity of the light-emitting diode is improved.

## Claims

**1.** A semiconductor device comprising:

a quantum-wave interference layer having plural periods of a pair of a first layer made of $Al_xGa_{1-x}As$ and a second layer made of $Al_yGa_{1-y}As$ ($0 \leqq x < y \leqq 1$);
wherein each thickness of said first and said second layers is determined by multiplying by an odd number one fourth of a quantum-wave wavelength of carriers in each of said first and said second layers.

**2.** A semiconductor device according to claim 1,
wherein each thickness of said first and said second layers are determined by multiplying by an odd number one fourth of quantum-wave wavelength of carriers in each of said first and said second layers existing at the level near the lowest energy level of said second layer.

**3.** A semiconductor device according to claim 1,
wherein a wavelength $\lambda_{RW}$ in said first layer is determined by a formula $\lambda_{RW} = h/[2m_{RW}(E_R+V_R)]^{1/2}$, a wavelength $\lambda_{RB}$ in said second layer is determined by a formula $\lambda_{RB} = h/(2m_{RB}E_R)^{1/2}$, said thickness of said first layer $D_{RW}$ is determined by a formula $D_{RW} = n_{RW}\lambda_{RW}/4$, and said thickness of said second layer $D_{RB}$ is determined by a formula $D_{RB} = n_{RB}\lambda_{RB}/4$, where h, $m_{RW}$, $m_{RB}$, $E_R$, $V_R$, and $n_{RW}$ and $n_{RB}$ represent a Plank's constant, effective mass of said carrier in said first layer, effective mass of said carrier in said second layer, kinetic energy of carriers at the level near the lowest energy level in said second layer, potential energy of said second layer to said first layer, and odd numbers, respectively.

**4.** A semiconductor device according to claim 2, wherein a wavelength $\lambda_{RW}$ in said first layer is determined by a formula $\lambda_{RW} = h/[2m_{RW}(E_R+V_R)]^{1/2}$, a wavelength $\lambda_{RB}$ in said second layer is determined by a formula $\lambda_{RB} = h/(2m_{RB}E_R)^{1/2}$, said thickness of said first layer $D_{RW}$ is determined by a formula $D_{RW} = n_{RW}\lambda_{RW}/4$, and said thickness of said second layer $D_{RB}$ is determined by a formula $D_{RB} = n_{RB}\lambda_{RB}/4$, where h, $m_{RW}$, $m_{RB}$, $E_R$, $V_R$, and $n_{RW}$ and $n_{RB}$ represent a Plank's constant, effective mass of said carrier in said first layer, effective mass of said carrier in said second layer, kinetic energy of carriers at the level near the lowest energy level in said second layer, potential energy of said second layer to said first layer, and odd numbers, respectively.

**5.** A semiconductor device according to claim 1, wherein said quantum-wave interference layer comprises:

a plurality of partial quantum-wave interference layers $I_{Rk}$ with $T_{Rk}$ periods of a pair of said first, layer and said second layer being displaced in series by varying k as 1, 2, ..., and wherein index k of said plurality of said partial quantum-wave interference layers corresponds to index k of kinetic energy level $E_{Rk}+V_R$ and $E_{Rk}$ and said first and second layers have thicknesses of $n_{RWk}\lambda_{RWk}/4$, and $n_{RBk}\lambda_{RBk}/4$, respectively, where $E_{Rk}+V_R$ and $E_{Rk}$, $\lambda_{RWk}$ and $\lambda_{RBk}$, and $n_{RWk}$, $n_{RBk}$ represent kinetic energy level of carriers flowing into respective said first layer and said second layer, wavelength of quantum-wave of carriers flowing into respective said first layer and said second layer, and odd numbers, respectively, and $\lambda_{RWk}$ and $\lambda_{RBk}$ are determined by functions of $E_{Rk}+V_R$ and $E_{Rk}$, respectively.

**6.** A semiconductor device according to claim 1, wherein said quantum-wave interference layer comprises:

a plurality of partial quantum-wave interference layers, each of said partial quantum-wave interference layers having serial pairs of said first layer and said second layer with serial pairs of thicknesses of ($n_{RW1}\lambda_{RW1}/4$, $n_{RB1}\lambda_{RB1}/4$), ..., ($n_{RWk}\lambda_{RWk}/4$, $n_{RBk}\lambda_{RBk}/4$), ..., ($n_{RWj}\lambda_{RWj}/4$, $n_{RBj}\lambda_{RBj}/4$), and wherein index k in said partial quantum-wave interference layer corresponds to index k of kinetic energy level $E_{Rk}+V_R$ and $E_{Rk}$ and $E_{Rk}+V_R$ and $E_{Rk}$, $\lambda_{RWk}$ and $\lambda_{RBk}$, and $n_{RWk}$, $n_{RBk}$ represent kinetic energy level of carriers flowing into respective said first layer and said second layer, wavelength of quantum-wave of carriers flowing into respective said first layer and said second layer, and odd numbers, respectively, and $\lambda_{RWk}$ and $\lambda_{RBk}$ are determined by functions of $E_{Rk}+V_R$ and $E_{Rk}$, respectively.

**7.** A semiconductor device according to claim 1 comprising:

a $\delta_R$ layer for sharply varying energy band, being formed between said first and said second layers, wherein said $\delta_R$ layer is substantially thinner than that of said first and said second layers.

**8.** A semiconductor device according to claim 1, wherein said quantum-wave interference layer functions as a reflection layer for reflecting said carriers.

**9.** A semiconductor device according to claim 1, wherein an incident plane of quantum-wave in said quantum-wave interference layer is said second layer having enough thickness to prevent conduction of carriers by a tunneling effect.

**10.** A semiconductor device comprising:

a quantum-wave interference layer having plural periods of a pair of a first layer made of $Al_xGa_{1-x}As$ and a second layer made of $Al_yGa_{1-y}As$ ($0 \leqq x < y \leqq 1$), said second layer having a wider band gap than said first layer; wherein each thickness of said first and said second layers is determined by multiplying by an even number one fourth of a quantum-wave wavelength of carriers in each of said first and said second layers.

**11.** A semiconductor device according to claim 10, wherein each thickness of said first and said second layers by multiplying by an even number one fourth of quantum-wave wavelength of carriers in each of said first and said second layers existing at the level near the lowest energy level of said second layer.

**12.** A semiconductor device according to claim 10, wherein a wavelength $\lambda_{TW}$ in said first layer is determined by a formula $\lambda_{TW} = h/[2m_{TW}(E_T+V_T)]^{1/2}$, a wavelength $\lambda_{TB}$ in said second layer is determined by a formula $\lambda_{TB}$ =

$h/(2m_{TB}E_T)^{1/2}$, said thickness of said first layer $D_{TW}$ is determined by a formula $D_{TW} = n_{TW}\lambda_{TW}/4$, and said thickness of said second layer $D_{TB}$ is determined by a formula $D_{TB} = n_{TB}\lambda_{TB}/4$, where h, $m_{TW}$, $m_{TB}$, $E_T$, $V_T$, and $n_{TW}$ and $n_{TB}$ represent a Plank's constant, effective mass of said carrier in said first layer, effective mass of said carrier in said second layer, kinetic energy of carriers at the level near the lowest energy level in said second layer, potential energy of said second layer to said first layer, and even numbers, respectively.

**13.** A semiconductor device according to claim 11, wherein a wavelength $\lambda_{TW}$ in said first layer is determined by a formula $\lambda_{TW} = h/[2m_{TW}(E_T+V_T)]^{1/2}$, a wavelength $\lambda_{TB}$ in said second layer is determined by a formula $\lambda_{TB} = h/(2m_{TB}E_T)^{1/2}$, said thickness of said first layer $D_{TW}$ is determined by a formula $D_{TW} = n_{TW}\lambda_{TW}/4$, and said thickness of said second layer $D_{TB}$ is determined by a formula $D_{TB} = n_{TB}\lambda_{TB}/4$, where h, $m_{TW}$, $m_{TB}$, $E_T$, $V_T$, and $n_{TW}$ and $n_{TB}$ represent a Plank's constant, effective mass of said carrier in said first layer, effective mass of said carrier in said second layer, kinetic energy of carriers at the level near the lowest energy level in said second layer, potential energy of said second layer to said first layer, and even numbers, respectively.

**14.** A semiconductor device according to claim 10, wherein said quantum-wave interference layer comprises:

a plurality of partial quantum-wave interference layers $I_{Tk}$ with $T_{Tk}$ periods of a pair of said first layer and said second layer being displaced in series by varying k as 1, 2, ..., and
wherein index k of said plurality of said partial quantum-wave interference layers corresponds to index k of kinetic energy level $E_{Tk}+V_T$ and $E_{Tk}$ and said first and second layers have thicknesses of $n_{TWk}\lambda_{TWk}/4$, and $n_{TBk}\lambda_{TBk}/4$, respectively, where $E_{Tk}+V_T$ and $E_{Tk}$, $\lambda_{TWk}$ and $\lambda_{TBk}$, and $n_{TWk}$, $n_{TBk}$ represent kinetic energy level of carriers flowing into respective said first layer and said second layer, wavelength of quantum-wave of carriers flowing into respective said first layer and said second layer, and even numbers, respectively, and $\lambda_{TWk}$ and $\lambda_{TBk}$ are determined by functions of $E_{Tk}+V_T$ and $E_{Tk}$, respectively.

**15.** A semiconductor device according to claim 10,
wherein said quantum-wave interference layer comprises:

a plurality of partial quantum-wave interference layers, each of said partial quantum-wave interference layers having serial pairs of said first layer and said second layer with serial pairs of thicknesses of ($n_{TW1}\lambda_{TW1}/4$, $n_{TB1}\lambda_{TB1}/4$), ..., ($n_{TWk}\lambda_{TWk}/4$, $n_{TBk}\lambda_{TBk}/4$), ..., ($n_{TWj}\lambda_{TWj}/4$, $n_{TBj}\lambda_{TBj}/4$), and
index k in said partial quantum-wave interference layer corresponds to index k of kinetic energy level $E_{Tk}+V_T$ and $E_{Tk}$ and $E_{Tk}+V_T$ and $E_{Tk}$, $\lambda_{TWk}$ and $\lambda_{TBk}$, and $n_{TWk}$, $n_{TBk}$ represent kinetic energy level of carriers flowing into respective said first layer and said second layer, wavelength of quantum-wave of carriers flowing into respective said first layer and said second layer, and even numbers, respectively, and $\lambda_{TWk}$ and $\lambda_{TBk}$ are determined by functions of $E_{Tk}+V_T$ and $E_{Tk}$, respectively.

**16.** A semiconductor device according to claim 10 comprising:

a $\delta_T$ layer for sharply varying energy band, being formed between said first and said second layers, wherein said $\delta_T$ layer is substantially thinner than that of said first and said second layers.

**17.** A semiconductor device according to claim 1,
wherein said quantum-wave interference layer functions as a transmission layer for transmitting said carriers.

**18.** A light-emitting device comprising:

an n-type layer;
a p-type layer; and
an active layer sandwiched by said n-type layer and said p-type layer;
wherein one of said n-type layer and said p-type layer is a quantum-wave interference layer having plural periods of a pair of a first layer made of $Al_xGa_{1-x}As$ and a second layer made of $Al_yGa_{1-y}As$ ($0\leqq x<y\leqq 1$), and each thickness of said first and said second layers is determined by multiplying by an odd number one fourth of a quantum-wave wavelength of carriers in each of said first and said second layers.

**19.** A light-emitting device comprising:

an n-type layer;

a p-type layer; and

an active layer sandwiched by said n-type layer and said p-type layer;
wherein one of said n-type layer and said p-type layer is a quantum-wave interference layer having plural, periods of a pair of a first layer made of $Al_xGa_{1-x}As$ and a second layer made of $Al_yGa_{1-y}As$ ($0 \leqq x < y \leqq 1$), said second layer having a wider band gap than said first layer, and each thickness of said first and said second layers is determined by multiplying by an even number one fourth of a quantum-wave wavelength of carriers in each of said first and said second layers.

**20.** A light-emitting device according to claim 18,
wherein said active layer and said n-type layer or said p-type layer are connected by a hetero junction, said n-type layer and said p-type layer function as an n-type cladding layer and a p-type cladding layer, said quantum-wave interference layer is formed at least one of said n-type cladding layer and said p-type cladding layer, and carriers are reflected by said quantum-wave interference layer and confined in said active layer.

**21.** A field effect transistor comprising:

a quantum-wave interference layer adjacent to a channel;
wherein said quantum-wave interference layer has plural periods of a pair of a first layer made of $Al_xGa_{1-x}As$ and a second layer made of $Al_yGa_{1-y}As$ ($0 \leqq x < y \leqq 1$), and each thickness of said first and said second layers is determined by multiplying by an odd number one fourth of a quantum-wave wavelength of carriers in each of said first and said second layers.

**22.** A field effect transistor comprising:

a quantum-wave interference layer adjacent to a channel;
wherein said quantum-wave interference layer has plural periods of a pair of a first layer made of $Al_xGa_{1-x}As$ and a second layer made of $Al_yGa_{1-y}As$ ($0 \leqq x < y \leqq 1$), said second layer having a wider band gap than said first layer, and each thickness of said first and said second layers is determined by multiplying by an even number one fourth of a quantum-wave wavelength of carriers in each of said first and said second layers.

**23.** A photovoltaic device having a pn junction structure, comprising:

an n-layer; and
a p-layer;
wherein at least one of said n-layer and said p-layer is made of a quantum-wave interference layer having plural periods of a pair of a first layer made of $Al_xGa_{1-x}As$ and a second layer made of $Al_yGa_{1-y}As$ ($0 \leqq x < y \leqq 1$), and each thickness of said first and said second layers is determined by multiplying by an odd number one fourth of a quantum-wave wavelength of carriers in each of said first and said second layers.

FIG. 1

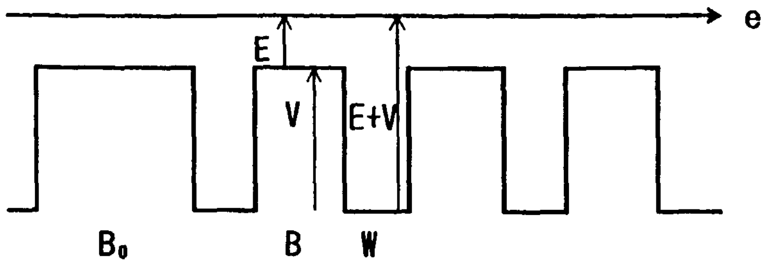


FIG. 2

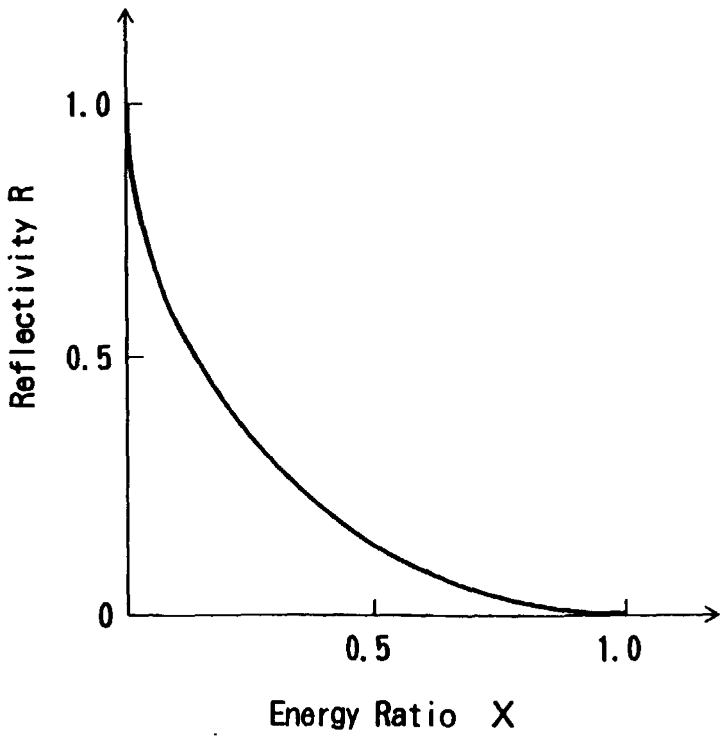

FIG. 3A

FIG. 3B

FIG. 3C

FIG. 3D

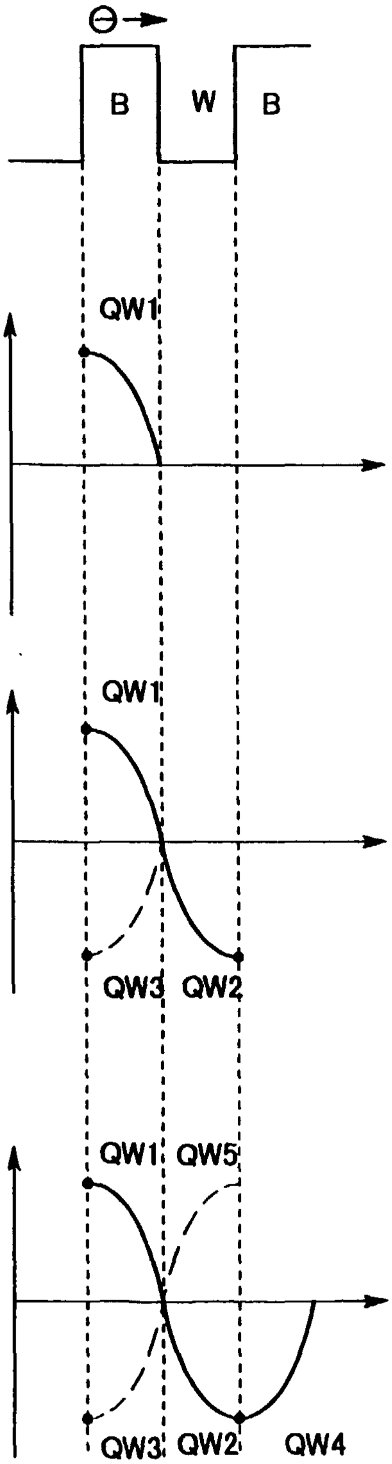

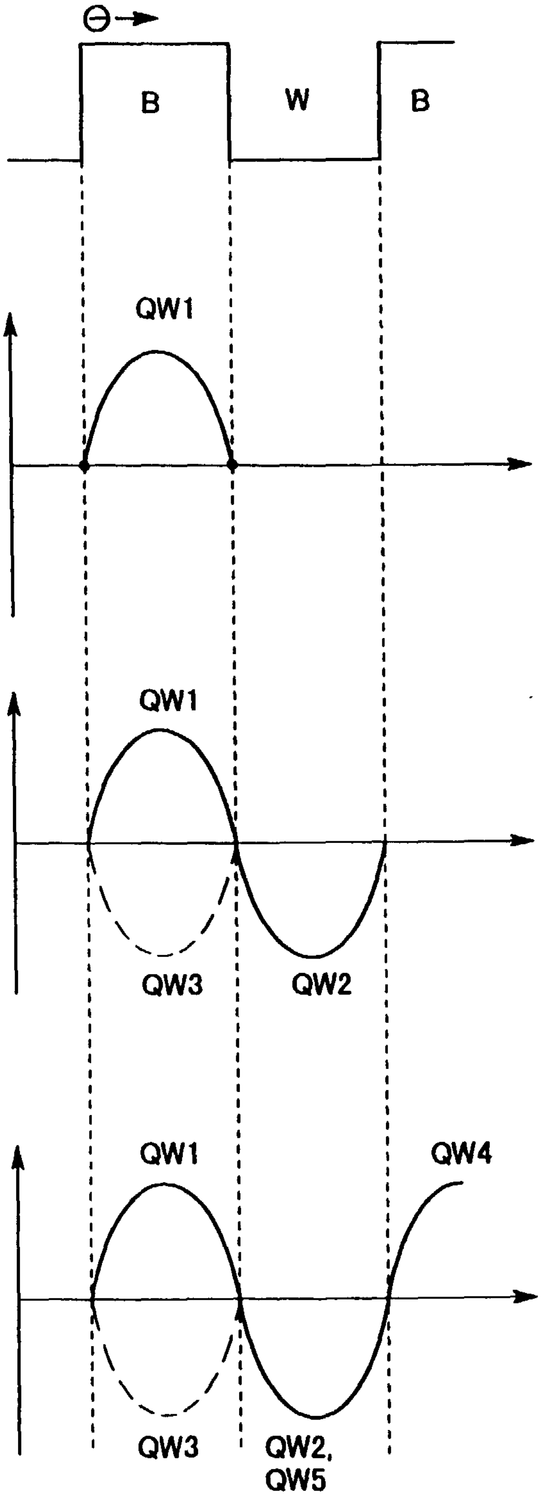


FIG. 3E

FIG. 3F

FIG. 3G

FIG. 3H

FIG. 4

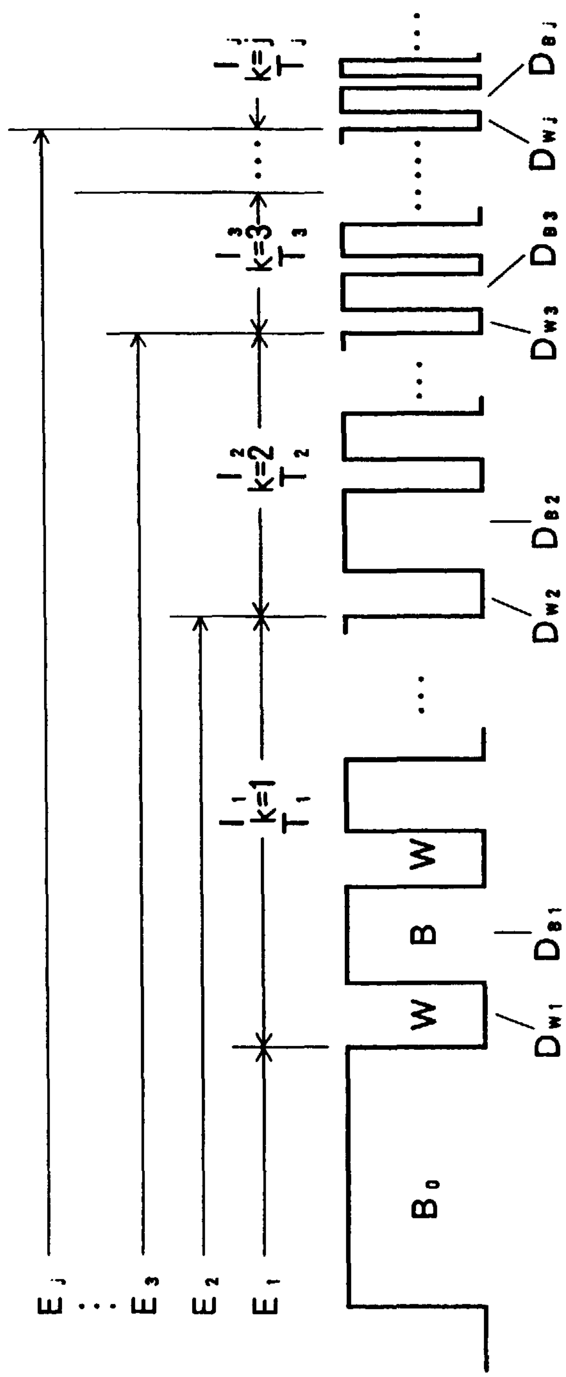

E1
E2
E3
Ej
B0
W
B
W
I1 k=1 T1
I2 k=2 T2
I3 k=3 T3
Ij k=j Tj
DW1
DB1
DW2
DB2
DW3
DB3
DWj
DBj

FIG. 5

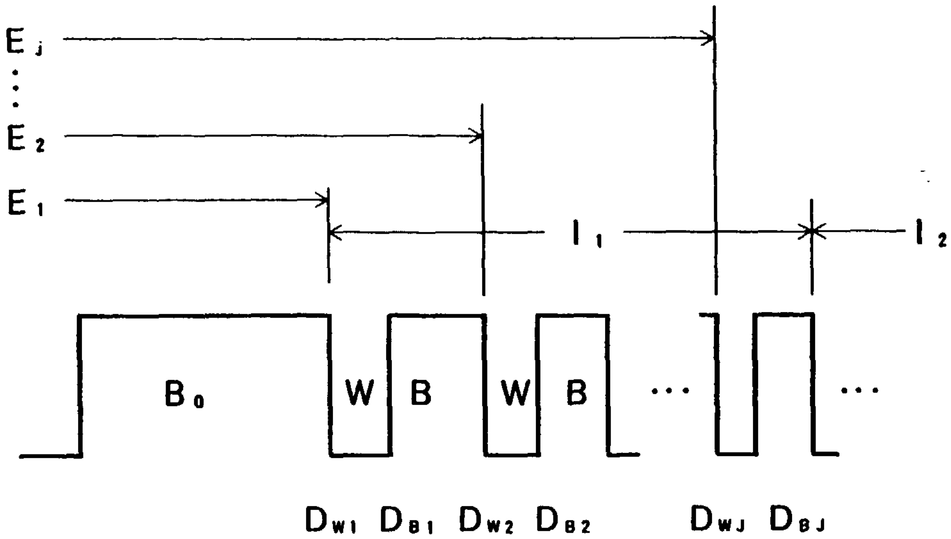

FIG. 6A

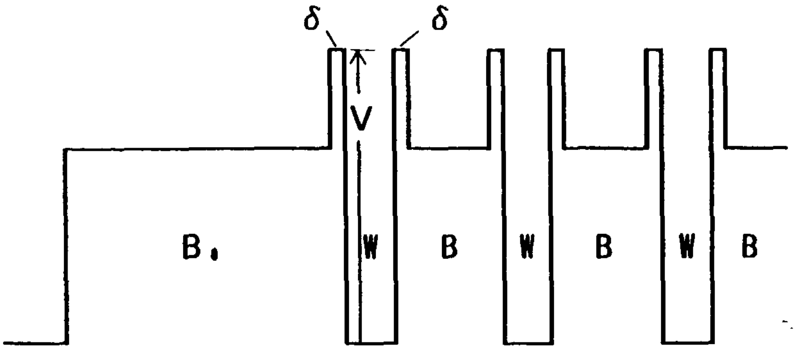


FIG. 6B

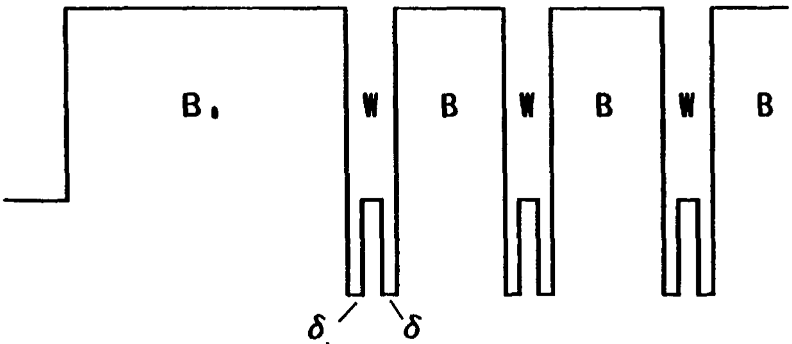


FIG. 6C

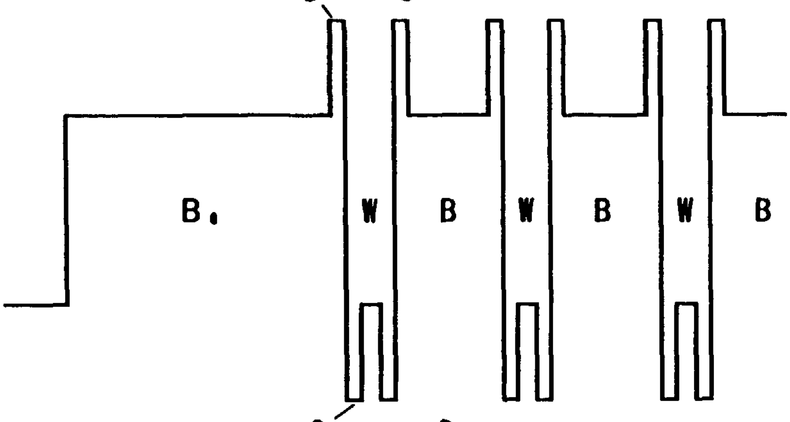


FIG. 6D

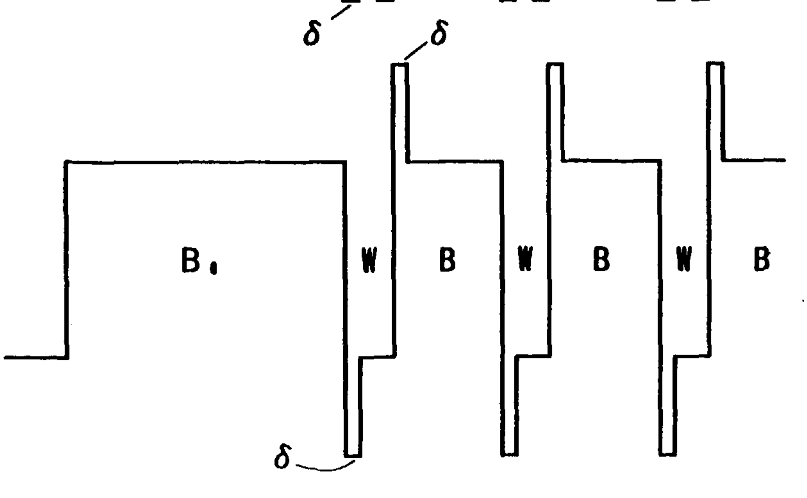

FIG. 7A

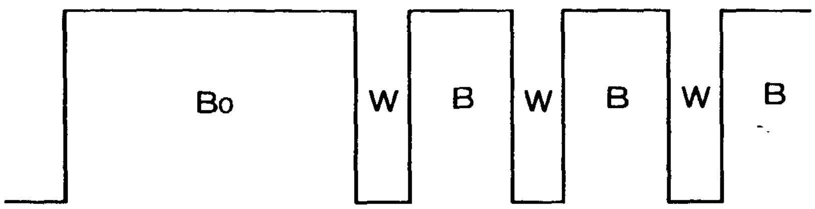


FIG. 7B

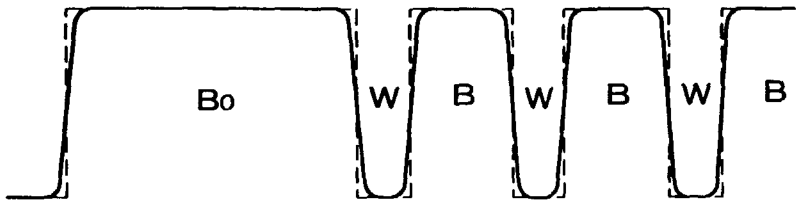


FIG. 7C

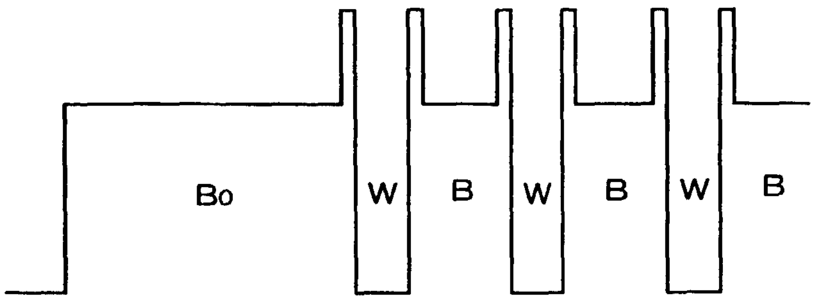


FIG. 7D

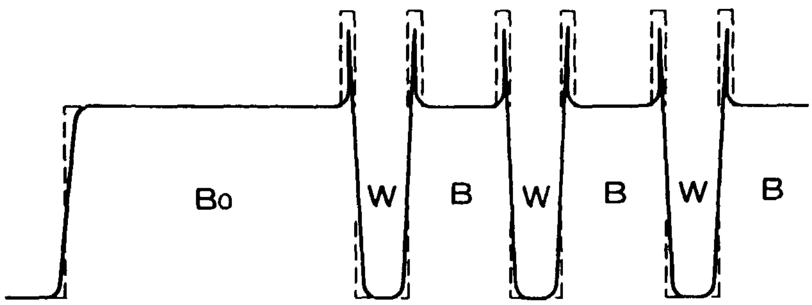

FIG. 8

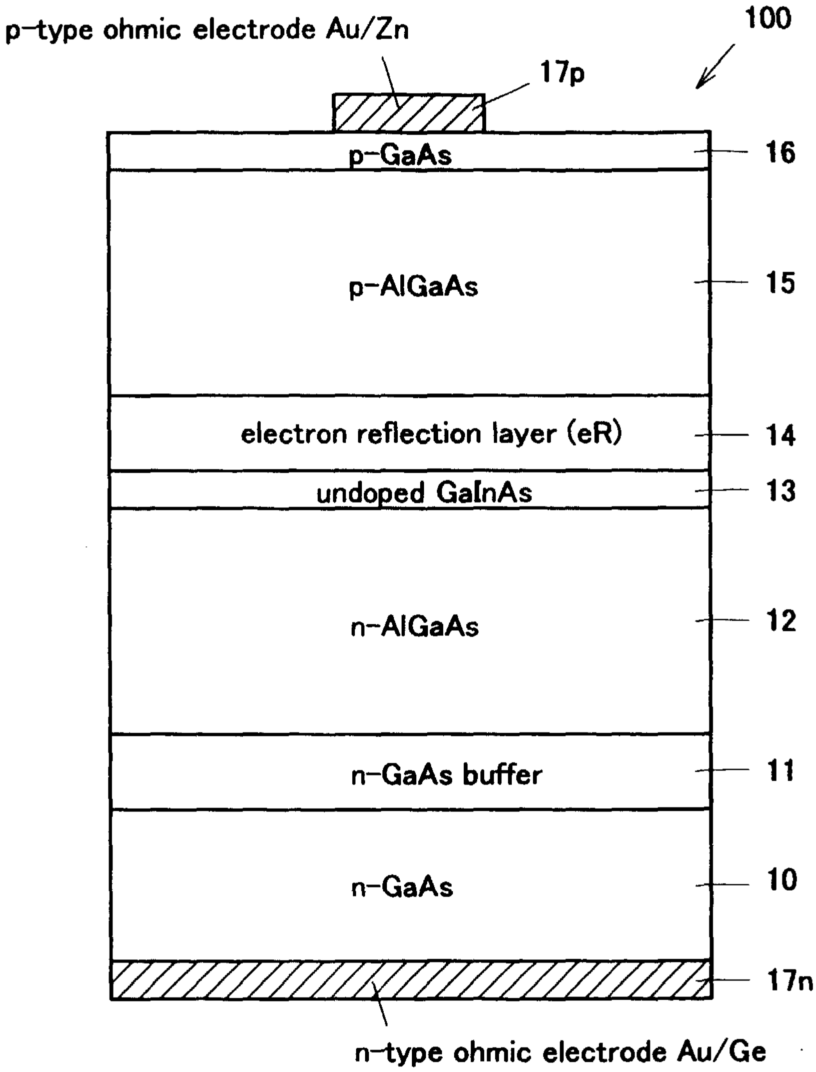
p-type ohmic electrode Au/Zn
100
17p
p-GaAs
16
p-AlGaAs
15
electron reflection layer (eR)
14
undoped GaInAs
13
n-AlGaAs
12
n-GaAs buffer
11
n-GaAs
10
17n
n-type ohmic electrode Au/Ge

FIG. 9A

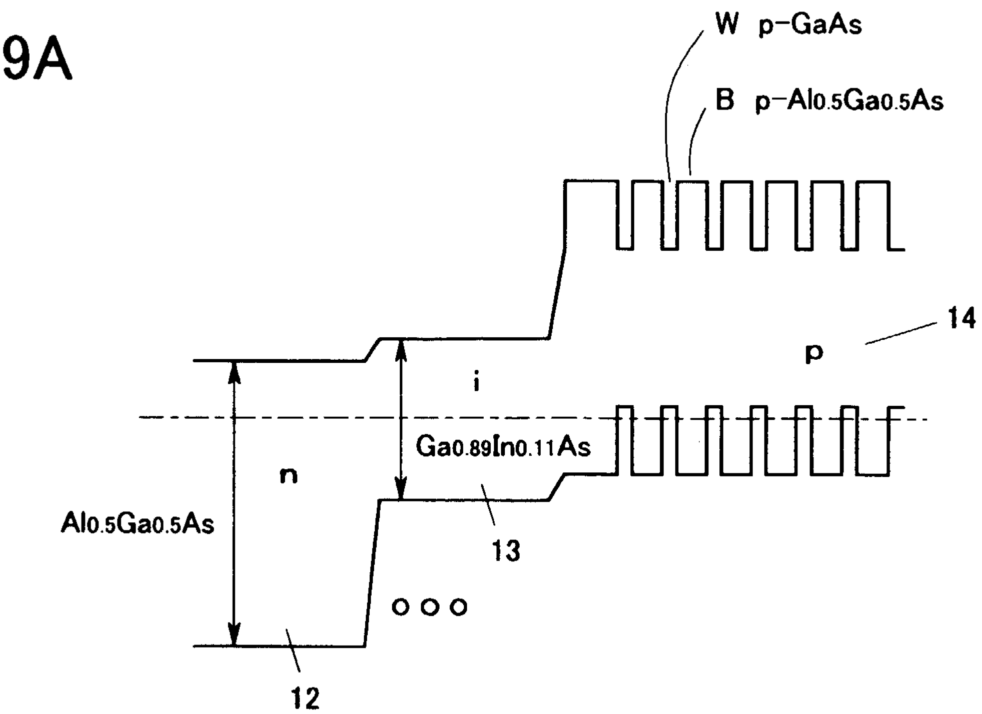
W p-GaAs
B p-Al0.5Ga0.5As
14
p
i
Ga0.89In0.11As
n
Al0.5Ga0.5As
13
12

FIG. 9B

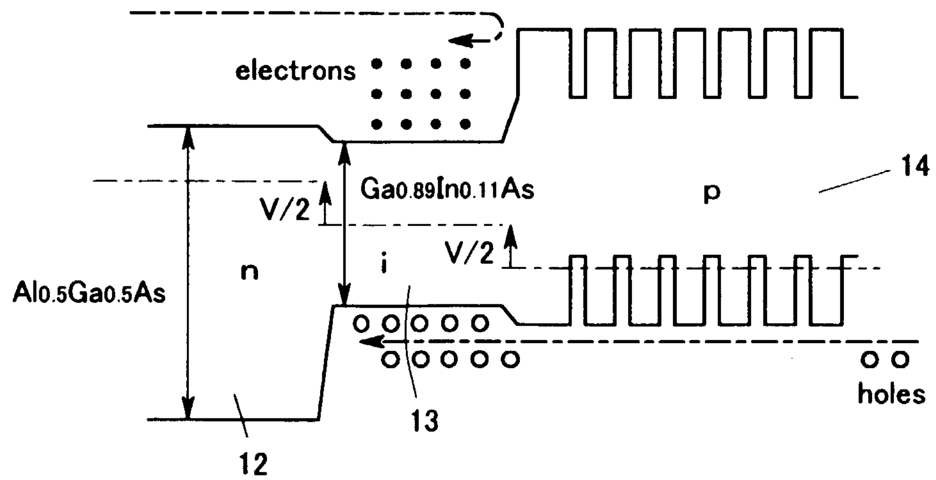
electrons
14
Ga0.89In0.11As
p
V/2
V/2
n
i
Al0.5Ga0.5As
holes
13
12

FIG. 10

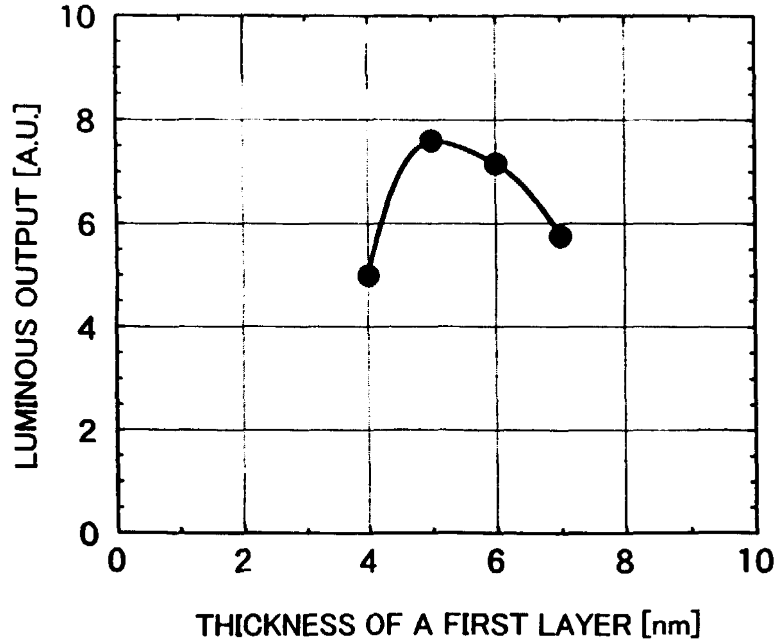
10
8
6
4
2
0
LUMINOUS OUTPUT [A.U.]
0
2
4
6
8
10
THICKNESS OF A FIRST LAYER [nm]

FIG. 11

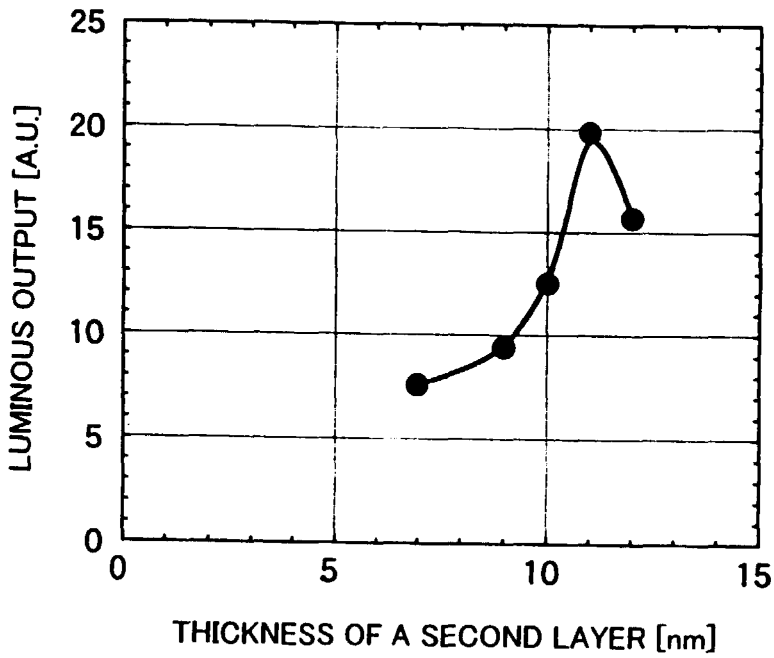
25
20
15
10
5
0
LUMINOUS OUTPUT [A.U.]
0
5
10
15
THICKNESS OF A SECOND LAYER [nm]

FIG. 12

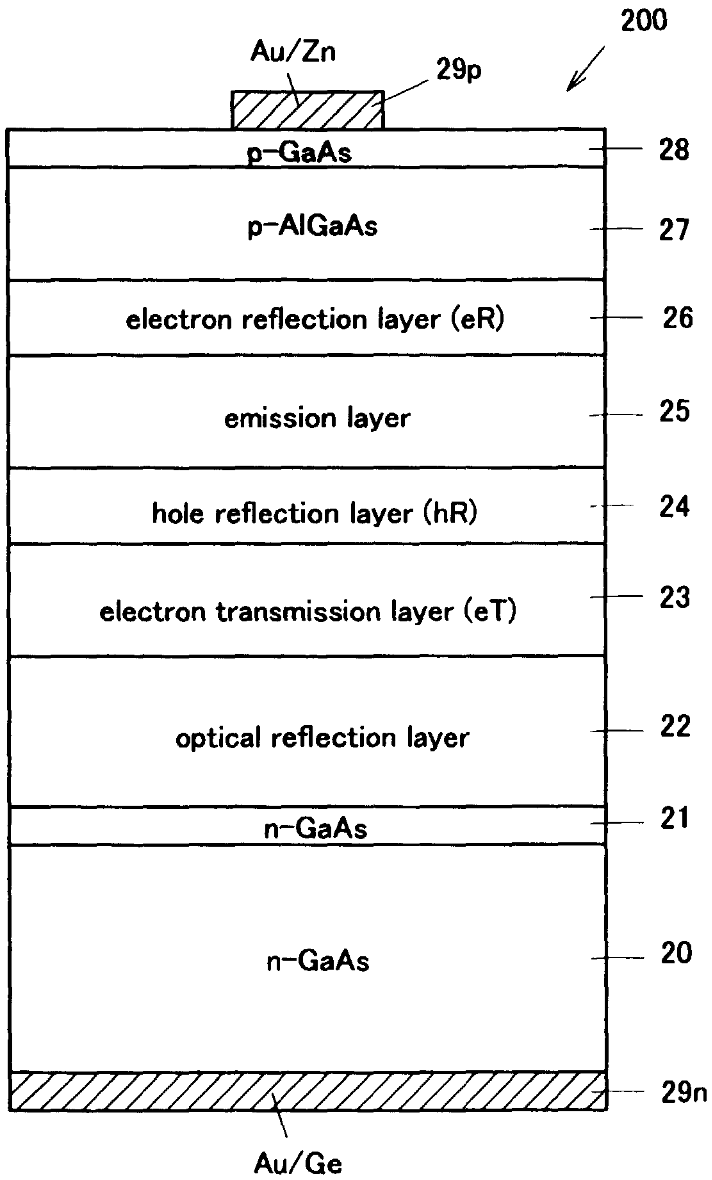
200
Au/Zn
29p
p-GaAs
28
p-AlGaAs
27
electron reflection layer (eR)
26
emission layer
25
hole reflection layer (hR)
24
electron transmission layer (eT)
23
optical reflection layer
22
n-GaAs
21
n-GaAs
20
29n
Au/Ge

FIG. 13A

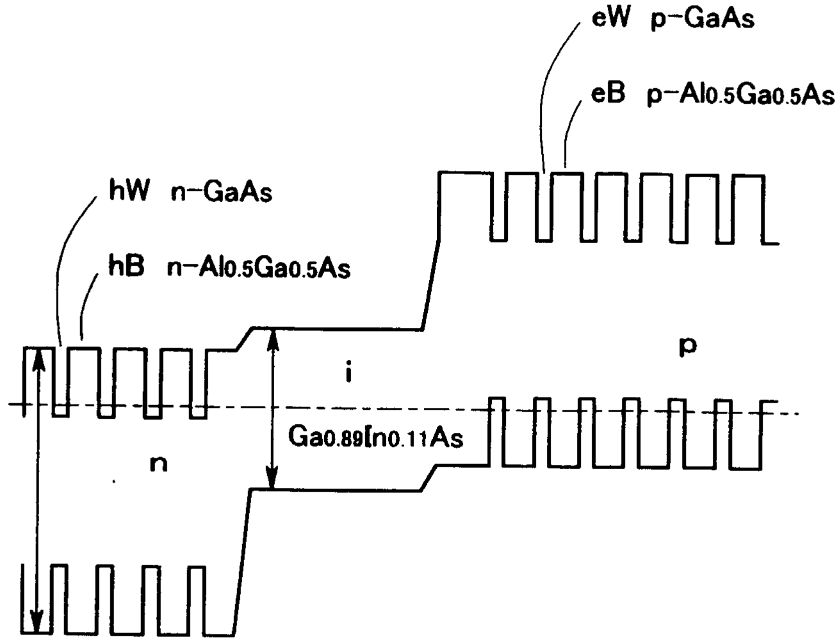


FIG. 13B

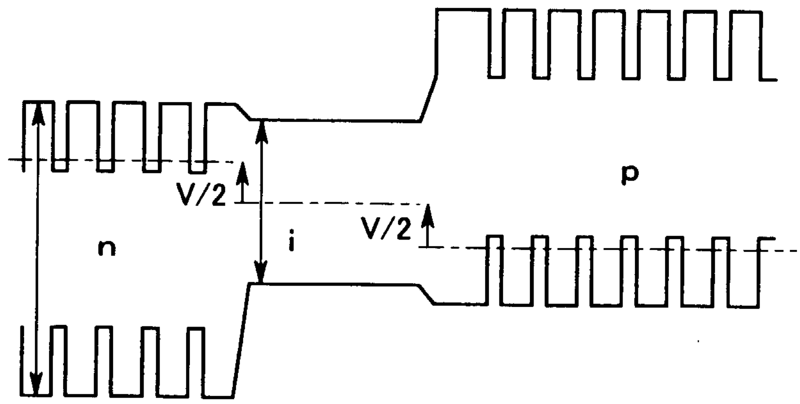

FIG. 14

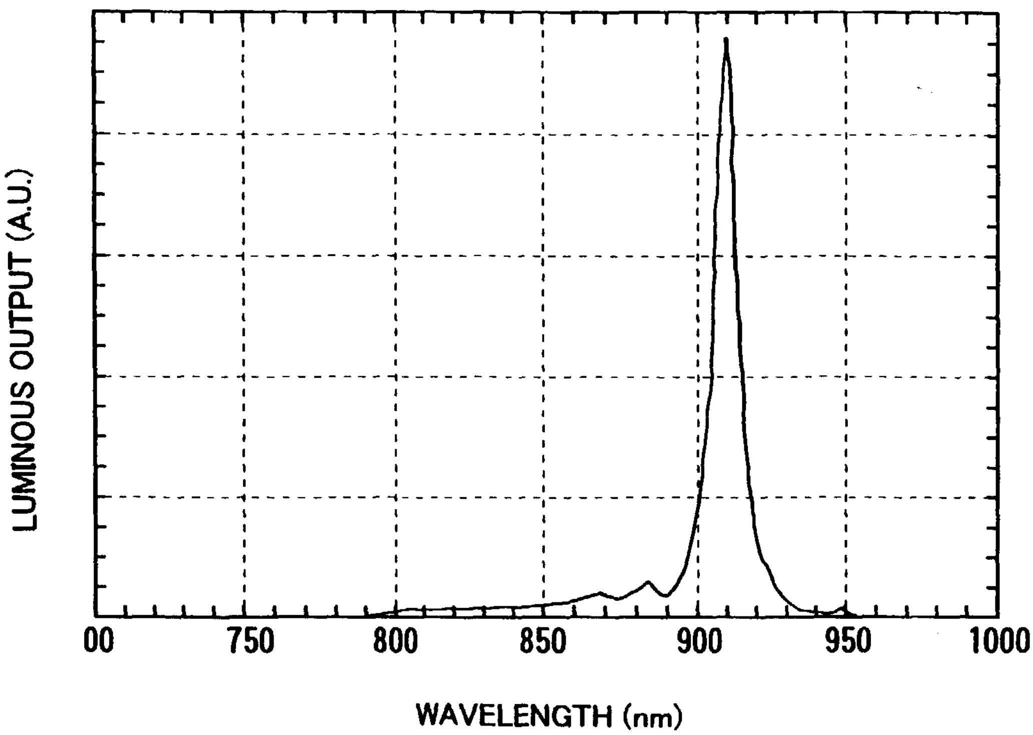

FIG. 15